# EUROPEAN PATENT APPLICATION

(11) **EP 4 307 335 A1**
(43) Date of publication of application: **17.01.2024**
(21) Application number: 22184444.2
(22) Date of filing: 12.07.2022
(51) Int. Cl.: H01J 37/12

(54) **ISOLATING SPACER FOR ELECTRON-OPTICAL ASSEMBLY**

(71) Applicant: ASML Netherlands B.V., 5500 AH Veldhoven (NL)
(72) Inventor: KONING, Johan, Joost, 5500 AH Veldhoven (NL)
(74) Representative: ASML Netherlands B.V.

(57) **Abstract**

A charged particle-optical assembly manipulates one or more charged particle beams. The assembly comprises: an upbeam element a downbeam element and an isolating spacer. The upbeam and down beam elements each comprie a plate having one or more apertures around a beam path of one or more charged particle beams. The spacer is for electrically isolate the upbeam element and the element from each other. The spacer defines a spacer aperture around the beam path of the one or more charged particle beams. The spacer comprises an upbeam portion adjacent to the upbeam element, a downbeam portion adjacent to the downbeam element and an intermediate portion between the upbeam portion and the downbeam portion. The upbeam portion and the downbeam portion protrude relative to the intermediate portion so the spacer aperture has an increased dimension at the intermediate portion compared to the upbeam portion and the downbeam portion.

## Description

### FIELD

The embodiments provided herein generally relate to an isolating spacer, a charged particle-optical assembly, a charged particle-optical device, a charged particle-optical apparatus, a method for electrically isolating an upbeam charged particle-optical element and a downbeam charged particle-optical element from each other, a method for controlling a charged particle-optical assembly, a method for making an isolating spacer and a method for making a charged particle-optical assembly.

### BACKGROUND

When manufacturing semiconductor integrated circuit (IC) chips, undesired pattern defects may occur on a substrate (e.g. wafer) or a mask during the fabrication processes, thereby reducing the yield. Defects may occur as a consequence of, for example, optical effects and incidental particles or other processing step such as etching, deposition of chemical mechanical polishing. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection tools with a charged particle beam have been used to inspect objects, for example to detect pattern defects. These tools typically use electron microscopy techniques, such as a scanning electron microscope (SEM). In a SEM, a primary electron beam of electrons at a relatively high energy is targeted with a final deceleration step in order to land on a target at a relatively low landing energy. The beam of electrons is focused as a probing spot on the target. The interactions between the material structure at the probing spot and the landing electrons from the beam of electrons cause electrons to be emitted from the surface, such as secondary electrons, backscattered electrons or Auger electrons, which together may be referred as signal electrons or more generally signal particles. The generated secondary electrons may be emitted from the material structure of the target.

By scanning the primary electron beam as the probing spot over the target surface, secondary electrons can be emitted across the surface of the target. By collecting these emitted secondary electrons from the target surface, a pattern inspection tool (or apparatus) may obtain an image-like signal representing characteristics of the material structure of the surface of the target. In such inspection the collected secondary electrons are detected by a detector within the apparatus. The detector generates a signal in response to the incidental particle. As an area of the sample is inspected, the signals comprise data which is processed to generate the inspection image corresponding to the inspected area of the sample. The image may comprise pixels. Each pixel may correspond to a portion of the inspected area. Typically electron beam inspection apparatus has a single beam and may be referred to as a Single Beam SEM. There have been attempts to introduce a multi-electron beam inspection in a apparatus (or a 'multi-beam tool') which may be referred to as Multi Beam SEM (MBSEM).

Another application for an electron-optical device (or column) is lithography. The charged particle beam reacts with a resist layer on the surface of a substrate. A desired pattern in the resist can be created by controlling the locations on the resist layer that the charged particle beam is directed towards.

An electron-optical device may be an apparatus for generating, illuminating, projecting and/or detecting one or more beams of charged particles. The path of the beam of charged particles is controlled by electromagnetic fields (i.e. electrostatic fields and magnetic fields). Stray electromagnetic fields can undesirably divert the beam.

In some electron-optical devices an electrostatic field is typically generated between two electrodes. There exists a need to apply high voltages to the electrodes. There is a possibility of electron creep and/or electrical discharges occurring undesirably between the electrodes.

### SUMMARY

The present invention provides a suitable architecture to enable the desired high voltage application with a reduced risk of electron creep and/or electrical discharge.

According to a first aspect of the invention, there is provided an isolating spacer for a charged particle-optical assembly for manipulating one or more charged particle beams between an upbeam charged particle-optical element and a downbeam charged particle-optical element that are controllable to have inverting polarity with respect to each other, the isolating spacer configured to electrically isolate the upbeam charged particle-optical element and the downbeam charged particle-optical element from each other, in the isolating spacer is defined a spacer aperture around a beam path of one or more charged particle beams, the isolating spacer comprises: an upbeam portion configured to be adjacent to an upbeam charged particle-optical element, a downbeam portion configured to be adjacent to an downbeam charged particle-optical element and an intermediate portion between the upbeam portion and the downbeam portion, wherein the upbeam portion and the downbeam portion protrude relative to the intermediate portion such that the spacer aperture has an increased dimension in a direction across the beam path at the intermediate portion compared to at the upbeam portion and the downbeam portion.

According to a second aspect of the invention, there is provided a charged particle-optical assembly configured to manipulate one or more charged particle beams, the charged particle-optical assembly comprising: an upbeam charged particle-optical element and a downbeam charged particle-optical element each comprising a plate having one or more apertures around a beam path of the one or more charged particle beams; and an isolating spacer configured to electrically isolate the upbeam charged particle-optical element and the downbeam charged particle-optical element from each other, the isolating spacer defining a spacer aperture around the beam path of the one or more charged particle beams; wherein the isolating spacer comprises an upbeam portion adjacent to the upbeam charged particle-optical element, a downbeam portion adjacent to the downbeam charged particle-optical element and an intermediate portion between the upbeam portion and the downbeam portion, wherein the upbeam portion and the downbeam portion protrude relative to the intermediate portion such that the spacer aperture has an increased dimension in a direction across the beam path at the intermediate portion compared to at the upbeam portion and the downbeam portion.

According to a third aspect of the invention, there is provided a method for electrically isolating an upbeam charged particle-optical element and a downbeam charged particle-optical element from each other in a charged particle-optical assembly configured to manipulate one or more charged particle beams, the method comprising: providing an upbeam charged particle-optical element and a downbeam charged particle-optical element each comprising a plate having one or more apertures around a beam path of the one or more charged particle beams; electrically isolating the upbeam charged particle-optical element and the downbeam charged particle-optical element from each other with an isolating spacer, the isolating spacer defining a spacer aperture around the beam path of the one or more charged particle beams; wherein the isolating spacer comprises an upbeam portion adjacent to the upbeam charged particle-optical element, a downbeam portion adjacent to the downbeam charged particle-optical element and an intermediate portion between the upbeam portion and the downbeam portion, wherein the upbeam portion and the downbeam portion protrude relative to the intermediate portion such that the spacer aperture has an increased dimension in a direction across the beam path at the intermediate portion compared to at the upbeam portion and the downbeam portion.

According to a fourth aspect of the invention, there is provided a method for controlling a charged particle-optical assembly to manipulate one or more charged particle beams, the method comprising: applying a potential difference across an upbeam charged particle-optical element and a downbeam charged particle-optical element each comprising a plate having one or more apertures around a beam path of the one or more charged particle beams; and changing the potential difference so that a direction of an electric field between the upbeam charged particle-optical element and the downbeam charged particle-optical element is reversed, optionally using a controller to control the potential differences applied to the upbeam charged particle-optical element and the downbeam charged particle-optical element; wherein an isolating spacer electrically isolates the upbeam charged particle-optical element and the downbeam charged particle-optical element from each other, the isolating spacer defining a spacer aperture around the beam path of the one or more charged particle beams; wherein the isolating spacer comprises an upbeam portion adjacent to the upbeam charged particle-optical element, a downbeam portion adjacent to the downbeam charged particle-optical element and an intermediate portion between the upbeam portion and the downbeam portion, wherein the upbeam portion and the downbeam portion protrude relative to the intermediate portion such that the spacer aperture has an increased dimension in a direction across the beam path at the intermediate portion compared to at the upbeam portion and the downbeam portion.

According to a fifth aspect of the invention, there is provided a method for making an isolating spacer for a charged particle-optical assembly configured to manipulate one or more charged particle beams, the isolating spacer configured to electrically isolate the upbeam charged particle-optical element and the downbeam charged particle-optical element from each other, the isolating spacer defining a spacer aperture around the beam path of the one or more charged particle beams, the method comprising: shaping two or more planar pieces of dielectric to have an aperture for a path of one or more charged particle beams, the different apertures having an inner rim; and fixing together the two or more planar pieces to form the isolating spacer, so that the isolating spacer has an inner surface comprising the inner rims of the two or more planar pieces such that the isolating spacer comprising an upbeam portion for securing to the upbeam charged particle-optical element, a downbeam portion for securing to the downbeam charged particle-optical element and an intermediate portion between the upbeam portion and the downbeam portion, the upbeam portion and the downbeam portion protruding relative to the intermediate portion such that the spacer aperture has an increased dimension in a direction across the beam path at the intermediate portion compared to at the upbeam portion and the downbeam portion.

According to a sixth aspect of the invention, there is provided a method for making a charged particle-optical assembly configured to manipulate one or more charged particle beams, the method comprising: providing an upbeam charged particle-optical element and a downbeam charged particle-optical element each comprising a plate having one or more apertures around a beam path of the one or more charged particle beams; and fixing the upbeam charged particle-optical element and the downbeam charged particle-optical element to either side of an isolating spacer configured to electrically isolate the upbeam charged particle-optical element and the downbeam charged particle-optical element from each other, the isolating spacer defining a spacer aperture around the beam path of the one or more charged particle beams; wherein the isolating spacer comprises an upbeam portion adjacent to the upbeam charged particle-optical element, a downbeam portion adjacent to the downbeam charged particle-optical element and an intermediate portion between the upbeam portion and the downbeam portion, wherein the upbeam portion and the downbeam portion protrude relative to the intermediate portion such that the spacer aperture has an increased dimension in a direction across the beam path at the intermediate portion compared to at the upbeam portion and the downbeam portion.

Advantages of the present invention will become apparent from the following description taken in conjunction with the accompanying drawings wherein are set forth, by way of illustration and example, certain embodiments of the present invention.

### BRIEF DESCRIPTION OF FIGURES

The above and other aspects of the present disclosure will become more apparent from the description of exemplary embodiments, taken in conjunction with the accompanying drawings.
Figure 1 is a schematic diagram illustrating an exemplary electron beam inspection apparatus.
Figure 2 is a schematic diagram illustrating an exemplary multi-beam electron-optical device that is part of the exemplary electron beam inspection apparatus of Figure 1.
Figure 3 is a schematic diagram of an exemplary electron-optical device comprising a collimator element array and a scan-deflector array that is part of the exemplary electron beam inspection apparatus of Figure 1.
Figure 4 is a schematic diagram of an exemplary electron-optical device array comprising the electron-optical devices of Figure 3.
Figure 5 is a schematic diagram of an alternative exemplary electron-optical device that is part of the exemplary electron beam inspection apparatus of Figure 1.
Figure 6 is a schematic diagram of an exemplary electron-optical assembly that may be part of the electron-optical devices of Figures 3, 4 and 5.
Figure 7 is a schematic diagram of an exemplary electron-optical assembly that may be part of the electron-optical devices of Figures 3, 4 and 5.
Figure 8 is a close-up view of part of an exemplary electron-optical assembly.
Figure 9 is a close-up view of part of an exemplary electron-optical assembly.
Figure 10 is a schematic diagram of an exemplary electron-optical assembly that may be part of the electron-optical devices of Figures 3, 4 and 5.
Figure 11 is a schematic diagram of an isolating spacer of an exemplary electron-optical assembly.
Figure 12 is a schematic diagram of an isolating spacer of an exemplary electron-optical assembly.
Figure 13 is a schematic diagram of an isolating spacer of an exemplary electron-optical assembly.

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

### BRIEF DESCRIPTION OF FIGURES

The reduction of the physical size of devices, and enhancement of the computing power of electronic devices, may be accomplished by significantly increasing the packing density of circuit components such as transistors, capacitors, diodes, etc. on an IC chip. This has been enabled by increased resolution enabling yet smaller structures to be made. Semiconductor IC manufacturing is a complex and time-consuming process, with hundreds of individual steps. An error in any step of the process of manufacturing an IC chip has the potential to adversely affect the functioning of the final product. Just one defect could cause device failure. It is desirable to improve the overall yield of the process. For example, to obtain a 75% yield for a 50-step process (where a step may indicate the number of layers formed on a wafer), each individual step must have a yield greater than 99.4%,. If an individual step has a yield of 95%, the overall process yield would be as low as 7-8%.

Maintaining a high substrate (i.e. wafer) throughput, defined as the number of substrates processed per hour, is also desirable. High process yield and high substrate throughput may be impacted by the presence of a defect. This is especially true if operator intervention is required for reviewing the defects. High throughput detection and identification of micro and nano-scale defects by inspection systems (such as a Scanning Electron Microscope ('SEM')) is desirable for maintaining high yield and low cost for IC chips.

A scanning electron microscope comprises a scanning device and a detector apparatus. The scanning device comprises an illumination apparatus that comprises an electron source, for generating primary electrons, and a projection apparatus for scanning a target, such as a substrate, with one or more focused beams of primary electrons. The primary electrons interact with the target and generate interaction products, such as signal particles e.g. secondary electrons and/or backscattered electrons. Secondary electrons may be considered to have an energy of up to 50eV. Backscatter electrons, although having an energy spectrum from substantially zero to the energy of the maximum of the charged particle device, are conventionally set to electrons (or signal electrons) having an energy exceeding 50eV. The detection apparatus captures the signal particles (e.g. secondary electrons and/or backscattered electrons) from the target as the target is scanned so that the scanning electron microscope may create an image of the scanned area of the target. A design of electron-optical apparatus embodying these scanning electron microscope features may have a single beam. For higher throughput such as for inspection, some designs of apparatus use multiple focused beams, i.e. a multi-beam, of primary electrons. The component beams of the multi-beam may be referred to as sub-beams or beamlets. A multi-beam may scan different parts of a target simultaneously. A multi-beam inspection apparatus may therefore inspect a target much quicker, e.g. by moving the target at a higher speed, than a single-beam inspection apparatus.

In a multi-beam inspection apparatus, the paths of some of the primary electron beams are displaced away from the central axis, i.e. a mid-point of the primary electron-optical axis (also referred to herein as the charged particle axis), of the scanning device. To ensure all the electron beams arrive at the sample surface with substantially the same angle of incidence, sub-beam paths with a greater radial distance from the central axis need to be manipulated to move through a greater angle than the sub-beam paths with paths closer to the central axis. This stronger manipulation may cause aberrations that cause the resulting image to be blurry and out-of-focus. An example is spherical aberrations which bring the focus of each sub-beam path into a different focal plane. In particular, for sub-beam paths that are not on the central axis, the change in focal plane in the sub-beams is greater with the radial displacement from the central axis. Such aberrations and de-focus effects may remain associated with the signal particles (e.g. secondary electrons) from the target when they are detected, for example the shape and size of the spot formed by the sub-beam on the target will be affected. Such aberrations therefore degrade the quality of resulting images that are created during inspection.

An implementation of a known multi-beam inspection apparatus is described below.

The Figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons, and items referred with reference to electrons, throughout the present document may therefore be more generally be considered to be references to charged particles, and items referred to in reference to charged particles, with the charged particles not necessarily being electrons.

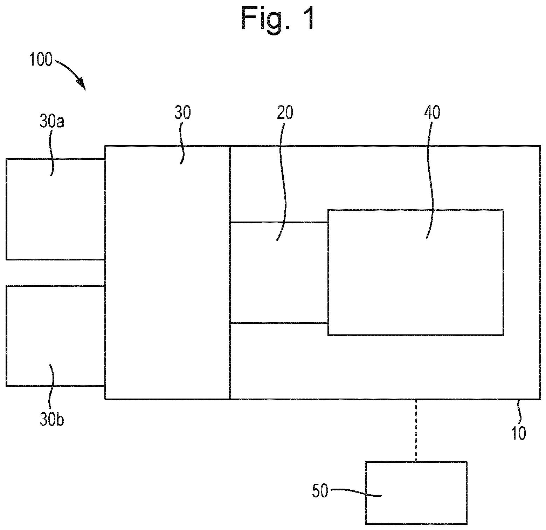

Reference is now made to Figure 1, which is a schematic diagram illustrating an exemplary electron beam assessment apparatus, or inspection apparatus, 100. The inspection apparatus 100 of Fig. 1 includes a vacuum chamber 10, a load lock chamber 20, an electron-optical apparatus, an equipment front end module (EFEM) 30 and a controller 50. The electron-optical device 40 may be within the vacuum chamber 10. The electron-optical apparatus may comprise an electron-optical device 40 (also known as an electron-optical device, an electron beam device or an electron beam device) and a motorized or actuated stage.

The EFEM 30 includes a first loading port 30a and a second loading port 30b. The EFEM 30 may include additional loading port(s). The first loading port 30a and second loading port 30b may, for example, receive substrate front opening unified pods (FOUPs) that contain substrates (e.g., semiconductor substrates or substrates made of other material(s)) or targets to be inspected (substrates, wafers and samples are collectively referred to as "targets" hereafter). One or more robot arms (not shown) in EFEM 30 transport the targets to load lock chamber 20.

The load lock chamber 20 is used to remove the gas around a target. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. The main chamber 10 is connected to a main chamber vacuum pump system (not shown). The main chamber vacuum pump system removes gas molecules in the main chamber 10 so that the pressure around the target reaches a second pressure lower than the first pressure. After reaching the second pressure, the target is transported to the electron-optical device 40 by which it may be inspected. An electron-optical device 40 may comprise either a single beam or a multi-beam electron-optical apparatus.

The controller 50 is electronically connected to the electron-optical device 40. The controller 50 may be a processor (such as a computer) configured to control the charged particle beam inspection apparatus 100. The controller 50 may also include a processing circuitry configured to execute various signal and image processing functions. While the controller 50 is shown in Figure 1 as being outside of the structure that includes the main chamber 10, the load lock chamber 20, and the EFEM 30, it is appreciated that the controller 50 may be part of the structure. The controller 50 may be located in one of the component elements of the charged particle beam inspection apparatus or it may be distributed over at least two of the component elements. While the present disclosure provides examples of main chamber 10 housing an electron beam inspection apparatus, it should be noted that aspects of the disclosure in their broadest sense are not limited to a chamber housing an electron-optical device. Rather, it is appreciated that the foregoing principles may also be applied to other apparatuses and other arrangements of apparatus that operate under the second pressure.

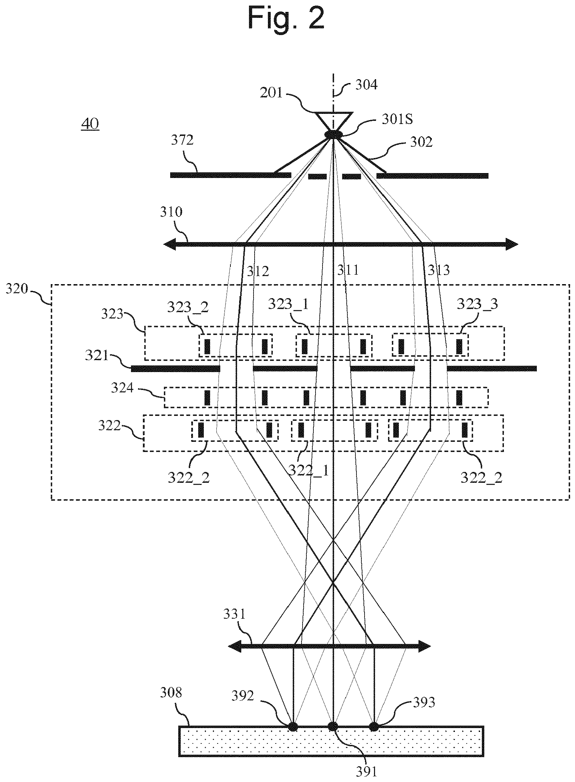

Reference is now made to Figure 2, which is a schematic diagram of an exemplary multi-beam electron-optical device 40 of an assessment apparatus, e.g. the inspection apparatus 100 of Figure 1. In an alternative embodiment the inspection apparatus 100 is a single-beam assessment apparatus. The electron-optical device 40 may comprise an electron source 201, a beam former array 372 (also known as a gun aperture plate, a coulomb aperture array or a pre-sub-beam-forming aperture array), a condenser lens 310, a source converter (or micro-optical array) 320, an objective lens 331, and a target 308. In an embodiment the condenser lens 310 is magnetic. (In a single beam assessment apparatus may have the same features as a multibeam assessment apparatus except electron-optical components with an array apertures 372, 320 may have a single aperture. The source converter 320 may be replaced with a number of electron-optical components along the beam path.) The target 308 may be supported by a support on a stage. The stage may be motorized. The stage moves so that the target 308 is scanned by the incidental electrons. The electron source 201, the beam former array 372, the condenser lens 310 may be the components of an illumination apparatus comprised by the electron-optical device 40. The source converter 320 (also known as a source conversion unit), described in more detail below, and the objective lens 331 may be the components of a projection apparatus comprised by the electron-optical device 40.

The electron source 201, the beam former array 372, the condenser lens 310, the source converter 320, and the objective lens 331 are aligned with a primary electron-optical axis 304 of the electron-optical device 40. The electron source 201 may generate a primary beam 302 generally along the electron-optical axis 304 and with a source crossover (virtual or real) 301S. During operation, the electron source 201 is configured to emit electrons. The electrons are extracted or accelerated by an extractor and/or an anode to form the primary beam 302.

The beam former array 372 cuts the peripheral electrons of primary electron beam 302 to reduce a consequential Coulomb effect. The primary-electron beam 302 may be trimmed into a specified number of sub-beams, such as three sub-beams 311, 312 and 313, by the beam former array 372. It should be understood that the description is intended to apply to an electron-optical device 40 with any number of sub-beams such as one, two or more than three. The beam former array 372, in operation, is configured to block off peripheral electrons to reduce the Coulomb effect. The Coulomb effect may enlarge the size of each of the probe spots 391, 392, 393 and therefore deteriorate inspection resolution. The beam former array 372 reduces aberrations resulting from Coulomb interactions between electrons projected in the beam. The beam former array 372 may include multiple openings for generating primary sub-beams even before the source converter 320.

The source converter 320 is configured to convert the beam (including sub-beams if present) transmitted by the beam former array 372 into the sub-beams that are projected towards the target 308. In an embodiment the source converter is a unit. Alternatively, the term source converter may be used simply as a collective term for the group of components that form the beamlets from the sub-beams.

As shown in Figure 2, in an embodiment the electron-optical device 40 comprises a beam-limiting aperture array 321 with an aperture pattern (i.e. apertures arranged in a formation) configured to define the outer dimensions of the beamlets (or sub-beams) projected towards the target 308. In an embodiment the beam-limiting aperture array 321 is part of the source converter 320. In an alternative embodiment the beam-limiting aperture array 321 is part of the system up-beam of the main device. In an embodiment, the beam-limiting aperture array 321 divides one or more of the sub-beams 311, 312, 313 into beamlets such that the number of beamlets projected towards the target 308 is greater than the number of sub-beams transmitted through the beam former array 372. In an alternative embodiment, the beam-limiting aperture array 321 keeps the number of the sub-beams incident on the beam-limiting aperture array 321, in which case the number of sub-beams may equal the number of beamlets projected towards the target 308.

As shown in Figure 2, in an embodiment the electron-optical device 40 comprises a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams 311, 312, and 313 onto the beam-limiting aperture array 321.

The electron-optical device 40 may also include an image-forming element array 322 with image-forming deflectors 322_1, 322_2, and 322_3. There is a respective deflector 322_1, 322_2, and 322_3 associated with the path of each beamlet. The deflectors 322_1, 322_2, and 322_3 are configured to deflect the paths of the beamlets towards the electron-optical axis 304. The deflected beamlets form virtual images (not shown) of source crossover 301S. In the current embodiment, these virtual images are projected onto the target 308 by the objective lens 331 and form probe spots 391, 392, 393 thereon. The electron-optical device 40 may also include an aberration compensator array 324 configured to compensate aberrations that may be present in each of the sub-beams. In an embodiment the aberration compensator array 324 comprises a lens configured to operate on a respective beamlet. The lens may take the form or an array of lenses. The lenses in the array may operate on a different beamlet of the multi-beam. The aberration compensator array 324 may, for example, include a field curvature compensator array (not shown) for example with micro-lenses. The field curvature compensator and micro-lenses may, for example, be configured to compensate the individual sub-beams for field curvature aberrations evident in the probe spots, 391, 392, and 393. The aberration compensator array 324 may include an astigmatism compensator array (not shown) with micro-stigmators. The micro-stigmators may, for example, be controlled to operate on the sub-beams to compensate astigmatism aberrations that are otherwise present in the probe spots, 391, 392, and 393.

The source converter 320 may further comprise a pre-bending deflector array 323 with pre-bending deflectors 323_1, 323_2, and 323_3 to bend the sub-beams 311, 312, and 313 respectively. The pre-bending deflectors 323_1, 323_2, and 323_3 may bend the path of the sub-beams onto the beam-limiting aperture array 321. In an embodiment, the pre-bending micro-deflector array 323 may be configured to bend the sub-beam path of sub-beams towards the orthogonal of the plane of on beam-limiting aperture array 321. In an alternative embodiment the condenser lens 310 may adjust the path direction of the sub-beams onto the beam-limiting aperture array 321. The condenser lens 310 may, for example, focus (collimate) the three sub-beams 311, 312, and 313 to become substantially parallel beams along primary electron-optical axis 304, so that the three sub-beams 311, 312, and 313 incident substantially perpendicularly onto source converter 320, which may correspond to the beam-limiting aperture array 321. In such alternative embodiment the pre-bending deflector array 323 may not be necessary.

The image-forming element array 322, the aberration compensator array 324, and the pre-bending deflector array 323 may comprise multiple layers of sub-beam manipulating devices, some of which may be in the form or arrays, for example: micro-deflectors, micro-lenses, or micro-stigmators. Beam paths may be manipulated rotationally. Rotational corrections may be applied by a magnetic lens. Rotational corrections may additionally, or alternatively, be achieved by an existing magnetic lens such as the condenser lens arrangement.

In the current example of the electron-optical device 40, the beamlets are respectively deflected by the deflectors 322_1, 322_2, and 322_3 of the image-forming element array 322 towards the electron-optical axis 304. It should be understood that the beamlet path may already correspond to the electron-optical axis 304 prior to reaching deflector 322_1, 322_2, and 322_3.

The objective lens 331 focuses the beamlets onto the surface of the target 308, i.e., it projects the three virtual images onto the target surface. The three images formed by three sub-beams 311 to 313 on the target surface form three probe spots 391, 392 and 393 thereon. In an embodiment the deflection angles of sub-beams 311 to 313 are adjusted to pass through or approach the front focal point of objective lens 331 to reduce or limit the off-axis aberrations of three probe spots 391 to 393. In an arrangement the objective lens 331 is magnetic. Although three beamlets are mentioned, this is by way of example only. There may be any number of beamlets.

A manipulator is configured to manipulate one or more beams of charged particles. The term manipulator encompasses a deflector, a lens and an aperture. The pre-bending deflector array 323, the aberration compensator array 324 and the image-forming element array 322 may individually or in combination with each other, be referred to as a manipulator array, because they manipulate one or more sub-beams or beamlets of charged particles. The lens and the deflectors 322_1, 322_2, and 322_3 may be referred to as manipulators because they manipulate one or more sub-beams or beamlets of charged particles.

In an embodiment a beam separator (not shown) is provided. The beam separator may be down-beam of the source converter 320. The beam separator may be, for example, a Wien filter comprising an electrostatic dipole field and a magnetic dipole field. The beam separator may be upbeam of the objective lens 331. The beam separator may be positioned between adjacent sections of shielding (described in more detail below) in the direction of the beam path. The inner surface of the shielding may be radially inward of the beam separator. Alternatively, the beam separator may be within the shielding. In operation, the beam separator may be configured to exert an electrostatic force by electrostatic dipole field on individual electrons of sub-beams. In an embodiment, the electrostatic force is equal in magnitude but opposite in direction to the magnetic force exerted by the magnetic dipole field of beam separator on the individual primary electrons of the sub-beams. The sub-beams may therefore pass at least substantially straight through the beam separator with at least substantially zero deflection angles. The direction of the magnetic force depends on the direction of motion of the electrons while the direction of the electrostatic force does not depend on the direction of motion of the electrons. So because the secondary electrons and backscattered electrons (or signal electrons) generally move in an opposite direction compared to the primary electrons, the magnetic force exerted on the secondary electrons and backscattered electrons (or signal particles) will no longer cancel the electrostatic force and as a result the secondary electrons and backscattered electrons moving through the beam separator will be deflected away from the electron-optical axis 304.

In an embodiment a secondary device (not shown) is provided comprising detection elements for detecting corresponding secondary charged particle beams. On incidence of secondary beams with the detection elements, the elements may generate corresponding intensity signal outputs. The outputs may be directed to an image processing system (e.g., controller 50). Each detection element may comprise an array which may be in the form of a grid. The array may have one or more pixels; each pixel may correspond to an element of the array. The intensity signal output of a detection element may be a sum of signals generated by all the pixels within the detection element.

In an embodiment a secondary projection apparatus and its associated electron detection device (not shown) are provided. The secondary projection apparatus and its associated electron detection device may be aligned with a secondary electron-optical axis of the secondary device. In an embodiment the beam separator is arranged to deflect the path of the secondary electron beams towards the secondary projection apparatus. The secondary projection apparatus subsequently focuses the path of secondary electron beams onto a plurality of detection regions of the electron detection device. The secondary projection apparatus and its associated electron detection device may register and generate an image of the target 308 using the secondary electrons or backscattered electrons (or signal particles).

Such Wien filter, a secondary device and/or a secondary projection apparatus may be provided in a single beam assessment apparatus. Additionally and/or alternatively a detection device may be present down beam of the objective lens, for example facing the sample during operation. In an alternative arrangement a detector device is position along the path of the charged particle beam towards the sample. In such an arrangement does not have a Wien filter, a secondary device and a secondary projection apparatus. The detection device may be positioned at one or more positions along the path of the charged particle beam path towards the sample, such as facing the sample during operation, for example around the path of the charged particle beam. Such a detector device may have an aperture and may be annular. The different detector devices may be positioned along the path of the charged particle to detect signal particles having different characteristics. The electron-optical elements along the path of the charged particle beam, which may include one or more electrostatic plates with an aperture for the path of the charged particle beam, may be arranged and controlled to focus the signal particles of different respective characteristics to a respective detector device at different positions along the path of charged particle beams. Such electro-static plates may be arranged in series of two or more adjoining plates along the path of the charged particle beam.

In an embodiment the inspection apparatus 100 comprises a single source.

Any element or collection of elements may be replaceable or field replaceable within the electron-optical device. The one or more electron-optical components in the electron-optical device, especially those that operate on sub-beams or generate sub-beams, such as aperture arrays and manipulator arrays may comprise one or more microelectromechanical systems (MEMS). The pre-bending deflector array 323 may be a MEMS. MEMS are miniaturized mechanical and electromechanical elements that are made using microfabrication techniques. In an embodiment the electron-optical device 40 comprises apertures, lenses and deflectors formed as MEMS. In an embodiment, the manipulators such as the lenses and deflectors 322_1, 322_2, and 322_3 are controllable, passively, actively, as a whole array, individually or in groups within an array, so as to control the beamlets of charged particles projected towards the target 308.

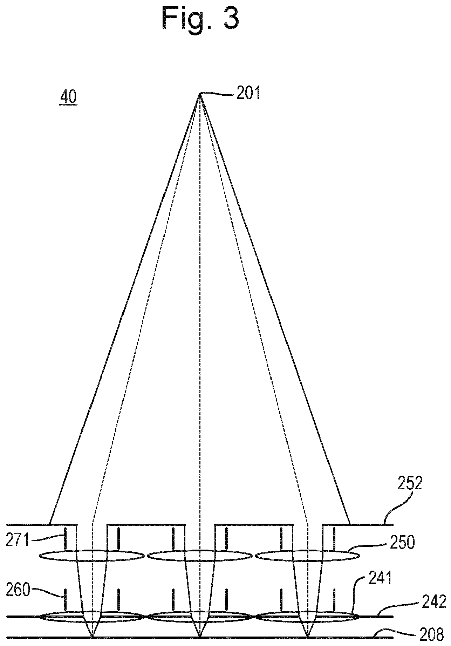

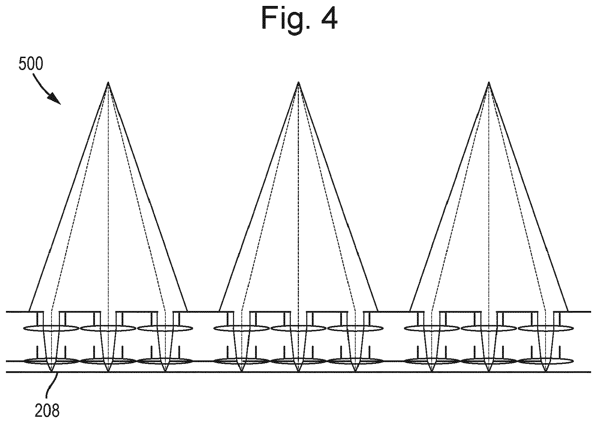

In an embodiment the electron-optical device 40 may comprise alternative and/or additional components on the charged particle path, such as lenses and other components some of which have been described earlier with reference to Figures. 1 and 2. Examples of such arrangements are shown in Figures 3 and 4 which are described in further detail later. In particular, embodiments include an electron-optical device 40 that divides a charged particle beam from a source into a plurality of sub-beams. A plurality of respective objective lenses may project the sub-beams onto a sample. In some embodiments, a plurality of condenser lenses is provided up-beam from the objective lenses. The condenser lenses focus each of the sub-beams to an intermediate focus up-beam of the objective lenses. In some embodiments, collimators are provided up-beam from the objective lenses. Correctors may be provided to reduce focus error and/or aberrations. In some embodiments, such correctors are integrated into or positioned directly adjacent to the objective lenses. Where condenser lenses are provided, such correctors may additionally, or alternatively, be integrated into, or positioned directly adjacent to, the condenser lenses and/or positioned in, or directly adjacent to, the intermediate foci. A detector is provided to detect charged particles emitted by the sample. The detector may be integrated into the objective lens. The detector may be on the bottom surface of the objective lens so as to face a sample in use. The detector may comprise an array, for example of detector elements, which may correspond to the array of the beamlets of the multi-beam arrangement. The detectors (or detector elements) in the detector array may generate detection signals that may be associated with the pixels of a generated image. The condenser lenses, objective lenses and/or detector may be formed as MEMS or CMOS devices.

Figure 3 is a schematic diagram of another design of an exemplary electron-optical device 40. The electron-optical device 40 may comprise a source 201 and one or more electron-optical assemblies. Alternatively, the electron-optical apparatus that comprises the electron-optical device 40 may comprise the source 201. The electron-optical device 40 may comprise an upper beam limiter 252, a collimator element array 271, a control lens array 250, a scan deflector array 260, an objective lens array 241, a beam shaping limiter 242 and a detector array. The source 201 provides a beam of charged particles (e.g. electrons). The multi-beam focused on the sample 208 is derived from the beam provided by the source 201. Sub-beams may be derived from the beam, for example, using a beam limiter defining an array of beam-limiting apertures. The source 201 is desirably a high brightness thermal field emitter with a good compromise between brightness and total emission current.

The upper beam limiter 252 defines an array of beam-limiting apertures. The upper beam limiter 252 may be referred to as an upper beam-limiting aperture array or up-beam beam-limiting aperture array. The upper beam limiter 252 may comprise a plate (which may be a plate-like body) having a plurality of apertures. The upper beam limiter 252 forms the sub-beams from the beam of charged particles emitted by the source 201. Portions of the beam other than those contributing to forming the sub-beams may be blocked (e.g. absorbed) by the upper beam limiter 252 so as not to interfere with the sub-beams down-beam. The upper beam limiter 252 may be referred to as a sub-beam defining aperture array.

The collimator element array 271 is provided down-beam of the upper beam limiter. Each collimator element collimates a respective sub-beam. The collimator element array 271 may be formed using MEMS manufacturing techniques so as to be spatially compact. In some embodiments, exemplified in Figure 3, the collimator element array 271 is the first deflecting or focusing electron-optical array element in the beam path down-beam of the source 201. In another arrangement, the collimator may take the form, wholly or partially, of a macro-collimator. Such a macro-collimator may be up beam of the upper beam limiter 252 so it operates on the beam from the source before generation of the multi-beam. A magnetic lens may be used as the macro-collimator.

Down-beam of the collimator element array there is the control lens array 250. The control lens array 250 comprises a plurality of control lenses. Each control lens comprises at least two electrodes (e.g. two or three electrodes) connected to respective potential sources. The control lens array 250 may comprise two or more (e.g. three) plate electrode arrays connected to respective potential sources. The control lens array 250 is associated with the objective lens array 241 (e.g. the two arrays are positioned close to each other and/or mechanically connected to each other and/or controlled together as a unit). The control lens array 250 is positioned up-beam of the objective lens array 241. The control lenses pre-focus the sub-beams (e.g. apply a focusing action to the sub-beams prior to the sub-beams reaching the objective lens array 241). The pre-focusing may reduce divergence of the sub-beams or increase a rate of convergence of the sub-beams.

As mentioned, the control lens array 250 is associated with the objective lens array 241. As described above, the control lens array 250 may be considered as providing electrodes additional to the electrodes 242, 243 of the objective lens array 241 for example as part of an objective lens array assembly. The additional electrodes of the control lens array 250 allow further degrees of freedom for controlling the electron-optical parameters of the sub-beams. In an embodiment the control lens array 250 may be considered to be additional electrodes of the objective lens array 241 enabling additional functionality of the respective objective lenses of the objective lens array 241. In an arrangement such electrodes may be considered part of the objective lens array providing additional functionality to the objective lenses of the objective lens array 241. In such an arrangement, the control lens is considered to be part of the corresponding objective lens, even to the extent that the control lens is only referred to as being a part of the objective lens for example in terms of providing one more extra degrees of freedom to the objective lens. Although the control lens array 241 may be indistinct from and part of the objective lens array 250, in this description the control lens array 250 is considered to be distinct and separate from the objective lens array 241.

For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of charged-particle arrangements such as those discussed herein, it will be understood however that lens arrays will typically operate electrostatically and so may not require any physical elements adopting a biconvex shape. As described above, lens arrays may instead comprise multiple plates with apertures.

The scan-deflector array 260 comprising a plurality of scan deflectors may be provided. The scan-deflector array 260 may be formed using MEMS manufacturing techniques. Each scan deflector scans a respective sub-beam over the sample 208. The scan-deflector array 260 may thus comprise a scan deflector for each sub-beam. Each scan deflector may deflect the sub-beam in one direction (e.g. parallel to a single axis, such as an X axis) or in two directions (e.g. relative to two non-parallel axes, such as X and Y axes). The deflection is such as to cause the sub-beam to be scanned across the sample 208 in the one or two directions (i.e. one dimensionally or two dimensionally). In an embodiment, the scanning deflectors described in EP2425444, which document is hereby incorporated by reference in its entirety specifically in relation to scan deflectors, may be used to implement the scan-deflector array 260. A scan-deflector array 260 (e.g. formed using MEMS manufacturing techniques as mentioned above) may be more spatially compact than a macro scan deflector. In another arrangement, a macro scan deflector may be used up beam of the upper beam limiter 252. Its function may be similar or equivalent to the scan-deflector array although it operates on the beam from the source before the beamlets of the multi-beam are generated.

The objective lens array 241 comprising a plurality of objective lenses is provided to direct the sub-beams onto the sample 208. Each objective lens comprises at least two electrodes (e.g. two or three electrodes) connected to respective potential sources. The objective lens array 241 may comprise two or more (e.g. three) plate electrode arrays connected to respective potential sources. Each objective lens formed by the plate electrode arrays may be a micro-lens operating on a different sub-beam. Each plate defines a plurality of apertures (which may also be referred to as holes). The position of each aperture in a plate corresponds to the position of a corresponding aperture (or apertures) in the other plate (or plates). The corresponding apertures define the objective lenses and each set of corresponding apertures therefore operates in use on the same sub-beam in the multi-beam. Each objective lens projects a respective sub-beam of the multi-beam onto a sample 208.

An objective lens array 241 having only two electrodes can have lower aberration than an objective lens array 241 having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beam. Such additional electrodes may be considered to form the control lens array 250. A benefit of a two electrode lens over an Einzel lens is that the energy of an incoming beam is not necessarily the same as an outgoing beam. Beneficially the potential differences on such a two electrode lens array enables it to function as either an accelerating or a decelerating lens array.

The objective lens array may form part of an objective lens array assembly along with any or all of the scan-deflector array 260, control lens array 250 and collimator element array 271. The objective lens array assembly may further comprise the beam shaping limiter 242. The beam shaping limiter 242 defines an array of beam-limiting apertures. The beam shaping limiter 242 may be referred to as a lower beam limiter, lower beam-limiting aperture array or final beam-limiting aperture array. The beam shaping limiter 242 may comprise a plate (which may be a plate-like body) having a plurality of apertures. The beam shaping limiter 242 is down-beam from at least one electrode (optionally from all electrodes) of the control lens array 250. In some embodiments, the beam shaping limiter 242 is down-beam from at least one electrode (optionally from all electrodes) of the objective lens array 241.

In an arrangement, the beam shaping limiter 242 is structurally integrated with an electrode 302 of the objective lens array 241. Desirably, the beam shaping limiter 242 is positioned in a region of low electrostatic field strength. Each of the beam-limiting apertures is aligned with a corresponding objective lens in the objective lens array 241. The alignment is such that a portion of a sub-beam from the corresponding objective lens can pass through the beam-limiting aperture and impinge onto the sample 208. The apertures of the beam shaping limiter 242 may have a smaller diameter than the apertures of at least one of the objective lens array 241, the control lens array 250, the detector array 240 and the upper beam limiter array 252. Each beam-limiting aperture has a beam limiting effect, allowing only a selected portion of the sub-beam incident onto the beam shaping limiter 242 to pass through the beam-limiting aperture. The selected portion may be such that only a portion of the respective sub-beam passing through a central portion of respective apertures in the objective lens array reaches the sample. The central portion may have a circular cross-section and/or be centered on a beam axis of the sub-beam.

In an embodiment, the electron-optical device 40 is configured to control the objective lens array assembly (e.g. by controlling potentials applied to electrodes of the control lens array 250) so that a focal length of the control lenses is larger than a separation between the control lens array 250 and the objective lens array 241. The control lens array 250 and objective lens array 241 may thus be positioned relatively close together, with a focusing action from the control lens array 250 that is too weak to form an intermediate focus between the control lens array 250 and objective lens array 241. The control lens array and the objective lens array operate together to for a combined focal length to the same surface. Combined operation without an intermediate focus may reduce the risk of aberrations. In other embodiments, the objective lens array assembly may be configured to form an intermediate focus between the control lens array 250 and the objective lens array 241.

An electric power source may be provided to apply respective potentials to electrodes of the control lenses of the control lens array 250 and the objective lenses of the objective lens array 241.

The provision of a control lens array 250 in addition to an objective lens array 241 provides additional degrees of freedom for controlling properties of the sub-beams. The additional freedom is provided even when the control lens array 250 and objective lens array 241 are provided relatively close together, for example such that no intermediate focus is formed between the control lens array 250 and the objective lens array 241. The control lens array 250 may be used to optimize a beam opening angle with respect to the demagnification of the beam and/or to control the beam energy delivered to the objective lens array 241. The control lens may comprise two or three or more electrodes. If there are two electrodes then the demagnification and landing energy are controlled together. If there are three or more electrodes the demagnification and landing energy can be controlled independently. Note, the most downbeam electrode of the control lens array 250 may be the most up-beam electrode of the objective lens array 241. That is the control lens array 250 and the objective lens array 241 may share an electrode. The shared electrode provides different lensing effects for each lens, each lensing effect with respect one its two opposing surfaces (i.e. up beam surface and down beam surface). The control lenses may thus be configured to adjust the demagnification and/or beam opening angle and/or the landing energy on the substrate of respective sub-beams (e.g. using the electric power source to apply suitable respective potentials to the electrodes of the control lenses and the objective lenses). This optimization can be achieved without having an excessively negative impact on the number of objective lenses and without excessively deteriorating aberrations of the objective lenses (e.g. without decreasing the strength of the objective lenses). Use of the control lens array enables the objective lens array to operate at its optimal electric field strength. Note that it is intended that the reference to demagnification and opening angle is intended to refer to variation of the same parameter. In an ideal arrangement the product of a range of demagnification and the corresponding opening angles is constant. However, the opening angle may be influenced by the use of an aperture.

In an embodiment, the landing energy can be controlled to a desired value in a predetermined range, e.g. from 1000 eV to 5000 eV. Desirably, the landing energy is primarily varied by controlling the energy of the electrons exiting the control lens. The potential differences within the objective lenses are preferably kept constant during this variation so that the electric field within the objective lens remains as high as possible. The potentials applied to the control lens in addition may be used to optimize the beam opening angle and demagnification. The control lens can function to change the demagnification in view of changes in landing energy. Desirably, each control lens comprises three electrodes so as to provide two independent control variables. For example, one of the electrodes can be used to control magnification while a different electrode can be used to independently control landing energy. Alternatively each control lens may have only two electrodes. When there are only two electrodes, one of the electrodes may need to control both magnification and landing energy.

The detector array (not shown) is provided to detect charged particles emitted from the sample 208. The detected charged particles may include any of the charged particles (e.g. signal particles) detected by a scanning electron microscope, including secondary (e.g. emitted) and/or backscattered electrons from the sample 208. The detector may be an array providing the surface of the electron-optical device facing the sample 208, e.g. the bottom surface of the electron-optical device. Alternative the detector array be up beam of the bottom surface or example in or up beam of the objective lens array or the control lens array. The elements of the detector array may correspond to the beamlets of the multi-beam arrangement. The signal generated by detection of an electron by an element of the array be transmitted to a processor for generation of an image. The signal may correspond to a pixel of an image.

In other embodiments both a macro scan deflector and the scan-deflector array 260 are provided. In such an arrangement, the scanning of the sub-beams over the sample surface may be achieved by controlling the macro scan deflector and the scan-deflector array 260 together, preferably in synchronization.

In an embodiment, as exemplified in Figure 4, an electron-optical device array 500 is provided. The array 500 may comprise a plurality of any of the electron-optical devices described herein. Each of the electron-optical devices focuses respective multi-beams simultaneously onto different regions of the same sample. Each electron-optical device may form sub-beams from a beam of charged particles from a different respective source 201. Each respective source 201 may be one source in a plurality of sources 201. At least a subset of the plurality of sources 201 may be provided as a source array. The source array may comprise a plurality of sources 201 provided on a common substrate. The focusing of plural multi-beams simultaneously onto different regions of the same sample allows an increased area of the sample 208 to be processed (e.g. assessed) simultaneously. The electron-optical devices in the array 500 may be arranged adjacent to each other so as to project the respective multi-beams onto adjacent regions of the sample 208.

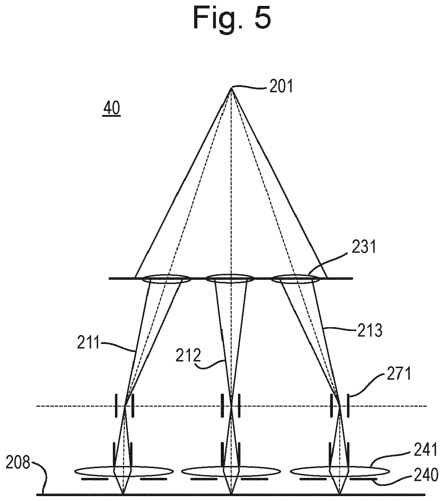

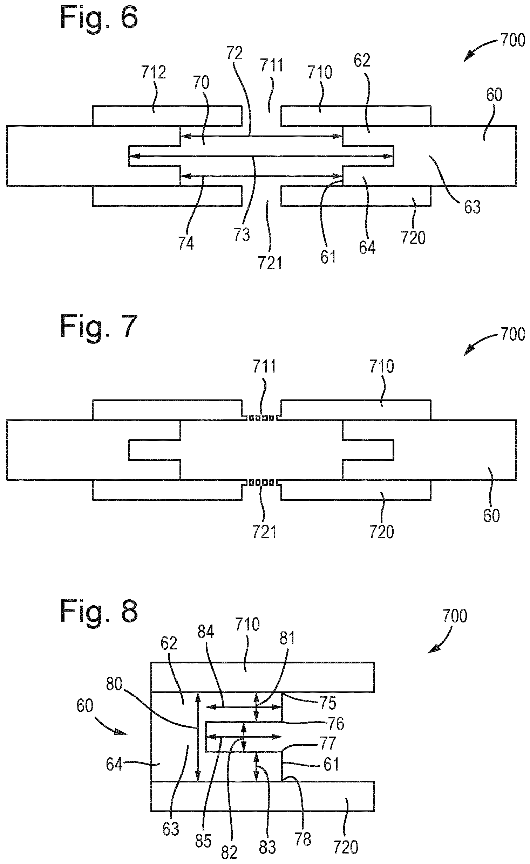

Any number of electron-optical devices may be used in the array 500. Preferably, the number of electron-optical devices is in the range of from two (2), desirably nine (9) to one hundred (100) even two hundred (200). In an embodiment, the electron-optical devices are arranged in a rectangular array or in a hexagonal array. In other embodiments, the electron-optical devices are provided in an irregular array or in a regular array having a geometry other than rectangular or hexagonal. Each electron-optical device in the array 500 may be configured in any of the ways described herein when referring to a single electron-optical device, for example as described above, especially with respect to the embodiment shown and described in reference to Figure 5 or Figure 6. Details of such an arrangement is described in EPA 20184161.6 filed 6 July 2020 which, with respect to how the objective lens is incorporated and adapted for use in the multi-device arrangement is hereby incorporated by reference.

In the example of Figure 4 the array 500 comprises a plurality of electron-optical devices of the type described above with reference to Figure 3. Each of the electron-optical devices in this example thus comprise both a scan-deflector array 260 and a collimator element array 271. As mentioned above, the scan-deflector array 260 and collimator element array 271 are particularly well suited to incorporation into an electron-optical device array 500 because of their spatial compactness, which facilitates positioning of the electron-optical devices close to each other. This arrangement of electron-optical device may be preferred over other arrangements that use a magnetic lens as collimator. Magnetic lenses may be challenging to incorporate into an electron-optical device intended for use in a multi-device arrangement (e.g. multi-column arrangement) for example because of magnetic interference between columns.

An alternative design of multi-beam electron-optical device may have the same features as described with respect to Figure 3 expect as described below and illustrated in Figure 5. The alternative design of multi-beam electron-optical device may comprise a condenser lens array 231 upbeam of the object lens array arrangement 241, as disclosed in EP application 20158804.3 filed on 21 February 2020 which is hereby incorporated by reference so far as the description of the multi-beam device with a collimator and its components. Such a design does not require the beam shaping limiter array 242 or the upper beam limiter array 252 because a beam limiting aperture array associated with condenser lens array 231 may shape the beamlets 211, 212, 213 of the multi-beam from the beam of the source 201. The beam limiting aperture array of the condenser lens may also function as an electrode in the lens array.

The paths of the beamlets 211, 212, 213 diverge away from the condenser lens array 231. The condenser lens array 231 focuses the generated beamlets to an intermediate focus between the condenser lens array 231 and the objective lens array assembly 241 (i.e. towards the control lens array and the objective lens array). The collimator array 271 may be at the intermediate foci instead of associated with the objective lens array assembly 241.

The collimator may reduce the divergence of the diverging beamlet paths. The collimator may collimate the diverging beamlet paths so that they are substantially parallel towards the objective lens array assembly. Corrector arrays may be present in the multi-beam path, for example associated with the condenser lens array, the intermediate foci and the objective lens array assembly. The detector 240 may be integrated into the objective lens 241. The detector 240 may be on the bottom surface of the objective lens 241 so as to face a sample in use.

In an embodiment of the arrangement shown in and described with reference to Figure 5, the detector may be located in similar locations in the electron-optical device 40 as described with reference to and as shown in the electron-optical device of Figure 3. The detector 240 may be integrated into the objective lens array 241 and the control lens array 250 (when present as it is not depicted in Figure 5). The detector may have more than one detector at different positions along the paths of the sub-beams of the multibeam, for example each array associated with a different electron-optical element, such as an electrode of the objective lens array and/or the control lens array. The objective lens array 241 and associated electron-optical elements such as the control lens array 250 may be comprised in assembly which may be a monolithic assembly which may be referred to as an electron-optical assembly 700. In an embodiment a detector 240 is associated with, or even integrated into, a plate 710, 720 of the electron-optical assembly 700. For example, the detector 240 may be on the bottom surface of an electron-optical assembly 700 comprising objective lenses 241. The detector 240 may be provided with an electric connection 60 as described elsewhere in this document. In a variation, the detector has a detector array positioned up beam of the objective lens array (optionally and the control lens array 250) for example upbeam of the electron-optical assembly 700. Between the electron-optical assembly 700 and the detector array may be a Wien filter array that directs the charged particles beams in a downbeam direction towards the sample and directs signal particles from the sample to the detector array.

An electron-optical device array may have multiple multi-beam devices of this design as described with reference to the multi-beam device of Figure 3 as shown in Figure 4. The multiple multi-beam devices may be arranged in an array of multi-beam devices. Such an arrangement is shown and described in EP Application 20158732.6 filed on 21 February 2020 which is hereby incorporated by reference with respect to the multi-device arrangement of a multi-beam apparatus featuring the design of multi-beam device disclosed with a collimator at an intermediate focus. A further alternative design of multi-beam apparatus comprises multiple single beam devices. The single beams generated for the purposes of the invention herein described may be similar or equivalent to a multi-beam generated by a single device. Each device may have an associated detector. Such a multi-device apparatus may be arranged in an array of devices of three, four, nine, nineteen, fifty, one hundred or even two hundred devices each generating a single beam or beamlet (if of a single beam device) or a plurality of beams (if of multibeam devices). In this further alternative design the array of devices may have a common vacuum system, each device have a separate vacuum system or groups of devices are assigned different vacuum systems.

The electron-optical device 40 may be a component of an inspection (or assessment metro-inspection) apparatus or part of an e-beam lithography apparatus. The multi-beam charged particle apparatus may be used in a number of different applications that include electron microscopy in general, not just scanning electron microscopy, and lithography.

The electron-optical axis 304 describes the path of charged particles through and output from the source 201. The sub-beams and beamlets of a multi-beam may all be substantially parallel to the electron-optical axis 304 at least through the manipulators or electron -optical arrays, for example of the arrangement shown and described with reference to Figure 2, unless explicitly mentioned. The electron-optical axis 304 may be the same as, or different from, a mechanical axis of the electron-optical device 40. In context of the arrangement shown and described with respect to Figures 2 to 5, the electron-optical axis may correspond to the path of the central beam of the multibeam, for example beam 212. The beams of the multibeam are substantially parallel to each other (for example along the electron-optical axis 304) between collimation (e.g. the location of the collimator array 271 which correspond to a plane of intermediate foci (for example as shown in Figure 5) or an upper beam limiter 252) and the surface of the sample 208.

The electron-optical device 40 may comprise an electron-optical assembly 700 as shown in Figure 6 or Figure 7 for manipulating electron beamlets. For example, the electron-optical assembly 700 may comprise one or more of (in a non-limited list): the objective lens array 241, and/or the condenser lens array 231 and/or the collimator element array 271 and/or an individual beam corrector and/or a deflector and/or a Wien filter array. In particular, the objective lens 331 and/or the condenser lens 310 and/or the control lens 250 may comprise the electron-optical assembly 700.

The electron-optical assembly is configured to provide a potential difference between two or more plates (or substrates). An electrostatic field is generated between the plates, which act as electrodes. The electrostatic field results in an attraction force between the two plates. The attraction force may be increased with increasing potential difference.

As shown in Figure 7, in an embodiment, at least one of the plates has a thickness which is stepped such that the array plate is thinner in the region corresponding to the array of apertures than another region of the array plate. It is advantageous to have a stepped thickness, for example with two portions of the plate having different thicknesses, because at high potential differences the plate is subjected to higher electrostatic forces which can result in bending if the plate were a consistent thickness and, for example, too thin. Bending of the plate can adversely affect beam-to-beam uniformity. Thus, a thick plate is advantageous to mitigate bending. However, if the plate is too thick in the region of the array of apertures, it can result in undesirable electron beamlet deformation. Thus, a thin plate around the array of apertures is advantageous to mitigate electron beamlet deformation. That is in a region of the plate thinner than the rest of the plate the array of apertures may be defined. The stepped thickness of the plate thus reduces the likelihood of bending, without increasing the likelihood of beamlet deformation. In an embodiment the plates have uniform thickness including in the region corresponding to the array of apertures.

The exemplary electron-optical assembly shown in Figure 6 comprises an upbeam plate 710 of an upbeam electron-optical element, a downbeam plate 720 of a downbeam electron-optical element and an isolating spacer 60. In the upbeam plate 710, at least one aperture 711 (optionally an array of apertures 711 as shown in Figure 7) is defined for the path of electron beamlets. The upbeam plate 710 may be referred to as an array plate (although note that in an embodiment the upbeam plate 710 has a single aperture 711). The downbeam plate 720 may be referred to as an adjoining plate. The number of apertures in the upbeam plate 710, may correspond to the number of sub-beams in the multi-beam arrangement. In one arrangement there are fewer apertures than sub-beams in the multi-beam so that groups of sub-beam paths pass through an aperture. For example an aperture may extend across the multi-beam path; the aperture may be a strip or slit. In another arrangement, the apertures may be arranged in a grid (or two dimensional array) so that groups are of beams are arranged in a two dimensional array of groups of beams.. The isolating spacer 60 is disposed between the plates to separate the plates. The electron-optical assembly 700 is configured to provide a potential difference between the upbeam plate 710 and the downbeam plate 720. In an embodiment the upbeam plate 710 comprises a radially inward portion 712. The radially inward portion 712 is adjacent to a spacer aperture 70 defined by the isolating spacer 60, described in more detail below.

In the downbeam plate 720, another aperture 721 (or array of apertures 721 as shown in Figure 7) is defined for the path of the electron beamlets. As shown in Figure 7, in an embodiment the downbeam plate 720 may also have a thickness which is stepped such that the adjoining plate is thinner in the region corresponding to the array of apertures than another region of the downbeam plate. (Alternatively the downbeam plate 720 is substantially planar and/or has uniform thickness.) Preferably, the array of apertures 721 defined in the downbeam plate 720 has the same pattern as the array of apertures 711 defined in the upbeam plate 710. In an arrangement the pattern of the aperture(s) in the two plates may be different. For example, the number of apertures in the downbeam plate 720 may be fewer or greater than the number of apertures in the upbeam plate 710. As shown in Figure 6, in an arrangement there is a single aperture in the downbeam plate for all the paths of the sub-beams of the multi-beam. Preferably the apertures in the upbeam plate 710 and the downbeam plate 720, are substantially mutually well aligned. This alignment between the apertures is in order to limit lens aberrations.

The upbeam plate and the downbeam plate may each have a thickness of up to 1.5 mm at the thickest point of the plate, preferably 1 mm, more preferably 500 µm. In an arrangement, the downbeam plate (i.e., the plate closer to the sample) may have a thickness of between 100 µm and 300 µm at its thickest point. The downbeam plate preferably a thickness of between 200 µm and 150 µm at its thickest point. The upbeam plate (i.e., the plate farther from the sample) may have a thickness of up to 500 µm at its thickest point.

A surface of the upbeam plate between the thinner region of the plate 710 and the other region, e.g. the thicker region, of the plate, for example that provides the step is preferably orthogonal to the surface of the plate facing the downbeam plate 720 and/or the path of the multi-beam. Similarly, a surface of the downbeam plate 720 at the step between the thicker region (radially outward) and the inner region (radially inward) may preferably be orthogonal to the surface of the downbeam plate facing the upbeam plate 710.

A coating may be provided on a surface of the upbeam plate and/or the downbeam plate. Preferably both the coating is provided on the upbeam plate and the downbeam plate. The coating reduces surface charging which otherwise can result in unwanted beam distortion.

The coating is configured to survive a possible electric breakdown event between the array plate and the adjoining plate. Preferably, a low ohmic coating is provided, and more preferably a coating of 1 Ohms/square or lower is provided. The coating is preferably provided on the surface of the downbeam plate. The coating is more preferably provided between at least one of the plates and the isolator. The low ohmic coating reduces undesirable surface charging of the plate.

The upbeam plate and/or the downbeam plate may comprise a low bulk resistance material, preferably a material of 1 Ohm.m or lower, optionally 0.1 Ohm.m or lower, optionally 0.01 Ohm.m or lower, optionally 0.001 Ohm.m or lower, and optionally 0.0001 Ohm.m or lower. More preferably, the upbeam plate and/or the downbeam plate comprises doped silicon. Plates having a low bulk resistance have the advantage that they are less likely to fail because the discharge current is supplied/drained via the bulk and not, for example, via the thin coating layer.

The upbeam plate comprises a first wafer. The first wafer may be etched to generate the regions having different thicknesses. The first wafer may be etched in the region corresponding to the array of apertures, such that the array plate is thinner in the region corresponding to the array of apertures. For example, a first side of a wafer may be etched or both sides of the wafer may be etched to create the stepped thickness of the plate. The etching may be by deep reactive ion etching. Alternatively or additionally, the stepped thickness of the plate may be produced by laser-drilling or machining.

Alternatively, the upbeam plate may comprise a first wafer and a second wafer. The aperture array may be defined in the first wafer. The first wafer may be disposed in contact with the isolating spacer. A second wafer disposed on a surface of the first wafer in a region not corresponding to the aperture array. The first wafer and the second wafer may be joined by wafer bonding. The thickness of the upbeam plate in the region corresponding to the array of apertures may be the thickness of the first wafer. The thickness of the array plate in another region, other than the region of the array of apertures, for example radially outward of the aperture array, may be the combined thickness of the first wafer and the second wafer. Thus, the upbeam plate has a stepped thickness between the first wafer and the second wafer.

One of the upbeam plate and the downbeam plate is negatively charged with respect to the other plate. In an embodiment in one mode of operation the upbeam plate has a higher potential than the downbeam plate for example with respect to for example to a ground potential, the source or of the sample. In an embodiment in another mode of operation the upbeam plate has a lower potential than the downbeam plate for example with respect to for example to a ground potential, the source or of the sample. The electron-optical assembly may be configured to provide a potential difference of 5 kV or greater between the upbeam plate and the downbeam plate. Preferably, the potential difference is 10 kV or greater. More preferably, the potential difference is 20 kV or greater.

The isolating spacer 60 is preferably disposed between the upbeam plate and the downbeam plate such that the opposing surfaces of the plates are co-planar with each other. The isolating spacer 60 has an inner surface 61 facing the path of the beamlets. The isolating spacer 60 defines a spacer aperture 70, for the path of the electron beamlets.

A conductive coating may be applied to the isolating spacer 60. Preferably, a low ohmic coating is provided, and more preferably a coating of 0.5 Ohms/square or lower is provided.

The coating is preferably on the surface of the space facing the negatively charged plate, which is negatively charged with respect to the other plate. The coating may be put at the same electric potential as one of the plates. The coating is preferably on the surface of the isolating spacer facing the negatively charged plate. The coating is more preferably electrically connected to the negatively charged plate. The coating may ensure that there is an electrostatic field over voids in between the isolating spacer and the negatively charged plate.

In absence of such a coating on the isolating spacer, electric field enhancement may occur in those voids. This electric field enhancement can result in electric breakdown in these voids and thereby in electric potential instability of the negatively charged plate e,g, lower electrode. However in an embodiment the upper electrode may be negatively charged and so may have the same type of coating applied to a surface between the upper electrode and the isolating spacer. This potential instability results in varying lens strength over time, thereby defocusing the electron beams.

In an embodiment the inner surface 61 is shaped such that a creep path between the plates over the inner surface is longer than a minimum distance between the plates, for example over the inner surface of the spacer between the two different plates. Preferably, the inner surface 61 of the isolating spacer 60 is shaped to provide a creep length of 10 kV/mm or less, preferably 3 kV/mm or less.

The exemplary electron-optical assembly 700 of Figure 6 comprises an isolating spacer 60 defining a spacer aperture 70. In an embodiment the isolating spacer 60 has a stepped shape. The isolating spacer 60 is configured to electrically isolate the upbeam electron-optical element and the downbeam electron-optical element from each other. In an embodiment the isolating spacer 60 is configured to support the two electron-optical elements. The isolating spacer 60 defines the spacer aperture 70 around the beam path of the one or more electron beams. The spacer aperture 70 is a through hole for the path of the electron beam (optionally a multi-beam) from an upbeam side of the isolating spacer 60 to a downbeam side of the isolating spacer 60.

As shown in Figure 6 or Figure 7, for example, in an embodiment the isolating spacer 60 comprises an upbeam portion 62, a downbeam portion 64 and an intermediate portion 63. The upbeam portion 62 is adjacent to the upbeam electron-optical element. The downbeam portion 64 is adjacent to the downbeam electron-optical element. The intermediate portion 63 is between the upbeam portion 62 and the downbeam portion 64. In an embodiment the upbeam portion 62 and the downbeam portion 64 protrude relative to the intermediate portion 63. The inward protrusion of the upbeam portion 62 and the downbeam portion 64 relative to the intermediate portion 63 is such that the spacer aperture 70 has an increased dimension in a direction across the beam path at the intermediate portion 63 compared to at the upbeam portion 62 and the downbeam portion 64. In an embodiment the spacer aperture 70 has a larger diameter between the upbeam side and the downbeam side than at either the upbeam side or the downbeam side of the isolating spacer 60.

As shown in Figure 6, in an embodiment the spacer aperture 70 has different dimensions at different positions along the direction of the electron beams. In an embodiment the spacer aperture 70 has an upbeam dimension 72, a downbeam dimension 74 and an intermediate dimension 73. The intermediate dimension is at an intermediate position between the upbeam dimension 72 and the downbeam dimension 74. As shown in Figure 6 or Figure 7 for example, in an embodiment the intermediate dimension 73 is greater than the upbeam dimension 72. In an embodiment the intermediate dimension 73 is greater than the downbeam dimension 74. In an embodiment, the dimension may be a diameter. The dimension may be referred to as a width. The dimension is generally in a direction across, optionally orthogonal to, the beam path.

In the isolating spacer 60 is defined a spacer aperture 70 or opening which may define a through passage having a surface. The through passage may have at least three different diameters along the beam path through the spacer aperture 70. In an embodiment, a stepped surface, for example between portions of the through passage having different diameters, is angled and preferably parallel to at least one of the upbeam plate 710 and the downbeam plate 720 and/or orthogonal to the beam path.

As shown in Figure 6 or Figure 7, for example, in an embodiment the spacer aperture 70 defined in the isolating spacer 60 has a smaller dimension (or width) on a downbeam side of the isolating spacer 70 than at an intermediate portion 63 of the isolating spacer 60. In an embodiment the spacer aperture 70 defined in the isolating spacer 60 has a smaller dimension on an upbeam side of the isolating spacer 60 than at the intermediate portion 63 of the isolating spacer 60.

In an embodiment one of the upbeam plate 710 and the downbeam plate 720 is positively charged with respect to the other plate. In an embodiment the spacer aperture 70 (or spacer hole) facing the negatively charged plate has a smaller dimension than the opening (or hole) facing the positively charged plate. By providing that the spacer aperture 70 has a width that changes in a direction between the upbeam plate 710 and the downbeam plate 720, the electron creep length over the inner surface 61 of the isolating spacer 60 may be increased. An embodiment of the invention is expected to increase the electron creep length between the upbeam plate 710 and the downbeam plate 720.

Figure 8 is a close-up view of part of the electron-optical assembly 700 shown in Figure 6 or Figure 7, for example. As shown in Figure 8, a downbeam triple point 78 is formed at the junction between the isolating spacer 60, the downbeam plate 720 and the spacer aperture 70 (which may be representative of a junction with the vacuum). An upbeam triple point 75 may be formed between the isolating spacer 60, the upbeam plate 710 and the spacer aperture 70. In general, the permittivity of the material of the isolating spacer 60 is expected to be different from the permittivity of the spacer aperture 70 (which in an embodiment is vacuum). By shaping the isolating spacer 60 such that the spacer aperture 70 facing the negatively charged plate has a smaller dimension than at the intermediate portion 63, the electric field near the triple point adjacent to the negatively charged plate may be reduced.

For example, when the downbeam plate 720 is the negatively charged plate, then the electric field at or near the downbeam triple point 78 may be reduced. When the upbeam plate 710 is the negatively charged plate, the electric field at or near the upbeam triple point 75 may be reduced. By reducing the electric field near the triple point, the possibility of electrical discharge between the upbeam plate 710 and the downbeam plate 720 is reduced. An embodiment of the invention is expected to reduce the possibility of electrical breakdown which causes undesirable electrical discharge.

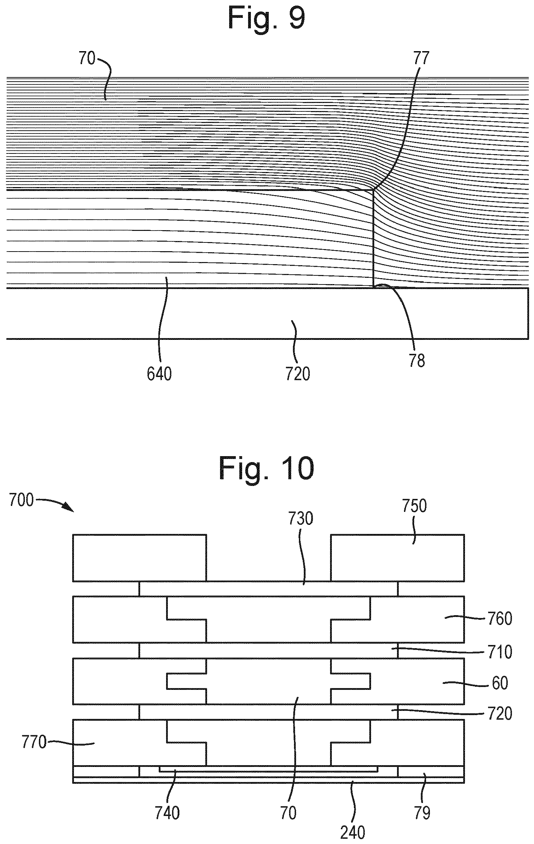

Figure 9 is a close-up view of part of the electron-optical assembly 700 shown in Figure 6 or Figure 7, for example. Figure 9 illustrates the results of a simulation showing the reduction in electric field strength near the downbeam triple point 78 as shown in and described with reference to Figure 8. In the example shown in Figure 9, the downbeam plate 720 is the negatively charged plate. The wavy lines across the figure (between the downbeam plate 720 and the top of the figure) are lines of constant potential. As shown in Figure 9, the local electric field near the downbeam triple point 78 is reduced relative to other parts of the surface of the isolating spacer 60. The possibility of electrical breakdown is reduced. In particular, in general an electrical discharge or electron creep may be expected to initiate at or near such a triple point. By reducing the electric field near such triple points, the possibility of electrical discharge and/or electron creep may be reduced. This outcome is unlike a similar design of a spacer of varying diameter of at least three portions along the beam path. In such a design an intermediate portion of the spacer has an aperture for the beam paths of smaller diameter than an upbeam portion and a downbeam portion. Although the creep length between plates upbeam and downbeam of the spacer, over the inner surface of the spacer aperture can be made longer than a minimum distance, such an arrangement has been found undesirably to increase or concentrate the local electric field near the downbeam triple point 78 between the spacer, one of the adjoining plates, for example the downbeam plate, and the beam aperture (i.e. vacuum) risking electrical breakdown.

As described elsewhere, in an embodiment the isolating spacer 60 is shaped such that the spacer aperture 70 facing both the upbeam plate 710 and the downbeam plate 720 has a smaller dimension than at the intermediate portion 63 of the isolating spacer 60. This allows the possibility of electron creep and/or electrical breakdown to be reduced regardless of which of the upbeam plate 710 and the downbeam plate 720 is the negatively charged plate. The isolating spacer 60 can reduce the possibility of electron creep and/or electric breakdown in both possible direction (polarities) of the electric field. For an electric field with a reversed polarity, the isolating spacer 60 may maintain its performance, i.e. maintain the electric breakdown potential. Electric field enhancement may be reduced or prevented from occurring near the negatively charged plate. The negatively charged plate is in general the source of the electrons when electron creep and/or electrical breakdown occur. The invention is therefore an improvement of known designs for meeting the desired performance specifications.

An embodiment of the invention is expected to allow the electric field between two adjacent electrodes such as the upbeam plate 710 and the downbeam plate 720 to reverse, without unduly increasing the possibility of electron creep and/or electrical breakdown. For example, it may be desirable to reverse the direction/plurality of the electric field in order to increase the range of possible electric potentials that may be applied to the different electrodes in the electron-optical assembly 700. The electron-optical assembly 700 may be or may comprise, for example, an objective lens and/or a control lens. By increasing the range of electric potentials that may be applied to the different electrodes, the electron-optical assembly 700 may support a greater range of landing energies. The landing energy is the energy of the electrons when they reach the sample position. An embodiment of the invention is expected to support holding electric fields in both directions. Embodiments of the invention may desirably beneficially provide improved operational parameter ranges and desirably improved opportunity for application of charged particle assessment such as in using the invention in an assessment apparatus having an embodiment of a charged particle device herein disclosed.

As shown in Figure 6 or Figure 7, for example, in an embodiment the isolating spacer 60 is shaped such that the spacer aperture 70 has a similar dimension in the direction across the beam path at the upbeam portion 62 and the downbeam portion 64. In an embodiment the spacer aperture 70 has the same dimension at the upbeam portion 62 and at the downbeam portion 64. However, it is not essential for the dimension of the spacer aperture 70 to be the same at the upbeam and downbeam portions 62, 64 (or upbeam and downbeam ends). In an embodiment the isolating spacer 60 is shaped such that the spacer aperture 70 has a greater dimension in the direction across the beam path at the upbeam portion 62 compared to at the downbeam portion 64. Alternatively, the spacer aperture 70 may have a smaller dimension at the upbeam portion 62 and at the downbeam portion 64.

In an embodiment the isolating spacer 60 is shaped to be symmetrical about a plane across the beam path. The plane may be through the intermediate portion 63. The isolating spacer 60 may have a mirrored shape. An upbeam half of the isolating spacer 60 may be reflective of the downbeam half of the isolating spacer 60. The isolating spacer 60 may be ambivalent with respect to the direction of the electric field between the upbeam plate 710 and the downbeam plate 720. An electric field may be applied in either direction between the upbeam plate 710 and the downbeam plate 720 having the isolating spacer 60 therebetween. An embodiment of the invention is expected to allow the possibility of electron creep and/or electrical breakdown to be reduced equally regardless of the direction of the electric field.

In an embodiment the electron-optical assembly 700 comprises a voltage supply electrically connected to at least one of the electron-optical elements. In an embodiment, a controller 50 is configured to control a potential difference applied by the voltage supply across the electron-optical elements. The controller 50 may control the voltage supply to apply different voltages to the upbeam plate 710 and the downbeam plate 720. The controller 50 may control the voltage supply so as to control how the electron beams are manipulated by the electron-optical assembly 700.

In an embodiment the isolating spacer 60 is shaped such that when a potential difference is applied across the electron-optical element, an electric potential at a protruding corner 76, 77 of the upbeam portion 62 and/or the downbeam portion 64 at which the dimension of the spacer aperture 70 changes is a locate extremum. As shown in Figure 8, in an embodiment the isolating spacer 60 comprises a protruding corner 76 of the upbeam portion 62 and a protruding corner 77 of the downbeam portion 64. As shown in Figure 8, in an embodiment the dimension of the spacer aperture 70 changes at the protruding corners 76, 77. There may be step change in the dimension (e.g. diameter of the spacer aperture 70 at the protruding corners 76, 77). The protruding corner 76 of the upbeam portion 62 is at the transition between the upbeam portion 62 and the intermediate portion 63. The protruding corner 77 of the downbeam portion 64 is at the transition between the intermediate portion 63 and the downbeam portion 64.

In the arrangement shown in Figure 9, the downbeam plate 720 is the negatively charged plate. The isolating spacer 60 may be shaped such that the potential difference (i.e. relative to a selected relative potential of the charged particle device 40 such as ground) at the protruding corner 77 is at a local maximum, i.e. relative to the rest of the portion of the spacer. This means that the electric potential decreases from the protruding corner 77 towards the downbeam triple point 78. The electric potential decreases from the protruding corner 77 along the step of the surfaces of the downbeam portion in the direction across the beam path. (Note if this scenario were to apply to the upbeam plate 710 i.e. by being the negatively charged plate, the relative potentials would be the same with respect to the upbeam portion 62 and it protruding corner 76. Further, if the scenario has one of the plates 720, 710 positively charged then the described characteristics of the relative potentials are opposite to those for the described scenario.) By providing that the protruding corner 76, 77 is at a local extremum, the possibility of electron creep via the protruding corner 76, 77 may be reduced. The protruding corner 76, 77 may form an electron trap. Electrons may become effectively trapped at the protruding corners 76, 77, not having sufficient energy to creep in either direction along the interface (shown as horizontal in the figure) between the intermediate portion 63 and the upbeam portion 62 or downbeam portion 64 of the isolating spacer 60.

As shown in Figures 6 to 9, in an embodiment the isolating spacer 60 is shaped such that there is a step change in the dimension of the spacer aperture 70 in the direction across the beam path between the intermediate portion 63 and the upbeam portion 62 and/or the downbeam portion 64. A step change means that there is a sudden (i.e. discontinuous) change in the value of the dimension of the spacer aperture 70. By providing a step change, the possibility of electrons creeping between the intermediate portion 63 and the upbeam portion 62 and/or the downbeam portion 64 may be reduced. In an embodiment the protruding corners 76, 77 are sharp corners. However, it is not essential for the protruding corners 76, 77 to be sharp. In an alternative embodiment, the protruding corners 76, 77 may be rounded. Desirably the radius of curvature of the corners, and thus of the rounding of the corners, is limited to realize the benefits described herein of the protruding corners 76, 77.

In an embodiment the isolating spacer 60 is shaped such that a difference in dimension in the spacer aperture 70 in the direction across the beam path at the intermediate portion 63 compared to at the upbeam portion 62 and/or the downbeam portion 64 is at least 10%, optionally at least 20%, optionally at least 50%, optionally at least 100%, optionally at least 200%, optionally at least 500%, optionally at least 1000% of the thickness 80 of the isolating spacer 60.

The thickness 80 of the isolating spacer 60 may be as shown in Figure 8. The difference in dimension of the spacer aperture 70 in the direction across the beam path at the intermediate portion 63, compared to at the upbeam portion 62 and the downbeam portion 64 may be as shown in Figure 8. In particular, the difference in dimension corresponds to twice the width 84, 85 of the step of the upbeam portion 62 and the downbeam portion 64, respectively. In an embodiment the width of the steps is of the same order of magnitude as the thickness of the isolating spacer 60. By providing a sufficiently wide step, the shape of the inner surface 61 of the isolating spacer 60 significantly increases the creep length.

In an embodiment the thickness 82 of the intermediate portion 63 is similar to the thickness 81 of the upbeam portion 62 and/or the thickness 83 of the downbeam portion 64. The thickness of the intermediate portion 63 may be greater than or smaller than the thickness 81 of the upbeam portion 62 and/or the thickness 83 of the downbeam portion 64.

In an embodiment the thickness 80 of the isolating spacer 60 is at least 0.2mm, optionally at least 0.5mm, optionally at least 1mm, optionally at least 2mm and optionally at least 3mm. In an embodiment the thickness 80 of the isolating spacer 60 is at most 20mm, optionally at most 10mm, optionally at most 5mm and optionally at most 3mm

In an embodiment the width 84 of the step of the upbeam portion 62 and/or the width 85 of the step of the downbeam portion 64 is at least 0.5mm, optionally at least 1mm, optionally at least 2mm, optionally at least 5mm, optionally at least 10mm and optionally at least 20mm. In an embodiment the width 84 of the step of the upbeam portion 62 and/or the width 85 of the step of the downbeam portion 64 is at most 20mm, optionally at most 10mm, optionally at most 5mm and optionally at most 2mm.

In an embodiment the thickness 81 of the upbeam portion 62 and/or the thickness 83 of the downbeam portion 64 is at least 0.2mm, optionally at least 0.5mm and optionally at least 1mm. In an embodiment the thickness 81 of the upbeam portion 62 and/or the thickness 83 of the downbeam portion 64 is at most 5mm, optionally at most 2mm and optionally at most 1mm

In an embodiment the thickness 82 of the intermediate portion 63 is at least 0.2mm, optionally at least 0.5mm and optionally at least 1mm. In an embodiment the thickness 82 of the intermediate portion 63 is at most 5mm, optionally at most 2mm and optionally at most 1mm

In an embodiment the thickness 82 of the intermediate portion 63 is at least 10%, optionally at least 20%, optionally at least 50% and optionally at least 80% of the combined thickness of the upbeam portion 62, the intermediate portion 63 and the downbeam portion 64. In an embodiment the thickness 82 of the intermediate portion 63 is at most 90%, optionally at most 80%, optionally at most 50% and optionally at most 20% of the combined thickness of the upbeam portion 62, the intermediate portion 63 and the downbeam portion 64.

In an embodiment the intermediate portion 63 is vertically centred (i.e. the thickness of the upbeam portion 62 may be the same as the thickness of the downbeam portion 64). Alternatively, the thickness of the upbeam portion 62 may be different from the thickness of the downbeam portion 64.

As mentioned above, in an embodiment the electron-optical assembly 700 is an electron-optical lens assembly. For example, the electron-optical lens assembly may comprise an objective lens assembly or may be an objective lens assembly. Alternatively, the electron-optical lens assembly may comprise a condenser lens assembly. However, it is not essential for the electron-optical assembly 700 to be or comprise an electron-optical lens assembly. Additionally or alternatively, the electron-optical assembly 700 may comprise, for example as a respective array, a collimator, a corrector such as an individual beam corrector, a detector array, a deflector and/or one or more elements of a Wien filter array. In general, any two adjacent electrodes (for example plates set to different potentials) within an electron-optical system may be electrically isolated from each other by an isolating spacer 60 according to an embodiment of the invention. The electron-optical assembly 700 may be a macro component that manipulates a single beam (which may be separated into multiple beams downbeam) that passes through a large aperture in the electron-optical assembly 700, for example, indicated in Figure 6. Alternatively, the electron-optical assembly 700 may comprise arrays of apertures and may be configured to manipulate a plurality of electron beams that pass through the apertures, for example as shown in Figure 7.

As shown in Figure 10, in an embodiment the electron-optical assembly 700 comprises at least four electron-optical elements each comprising a plate 710, 720, 730, 740. (The depicted arrangement can be considered to be an arrangement five electron-optical elements of which the fifth element may be a detector 240 as will be herein disclosed.) Each plate 710, 720, 730, 740 has one or more apertures around a beam path of the one or more electron beams. The arrangements shown in Figure 10 shows four length plates 710, 720, 730, 740 and a detector plate of the detector 240. The plates may be electrically isolated from each other. As shown in Figure 10, the isolating spacer 60 described above electrically isolates the upbeam plate 710 from the downbeam plate 720. The upbeam plate and the downbeam plate are located between a most upbeam electron-optical element (comprising a most upbeam plate 730) and a most downbeam electron-optical element (comprising a most downbeam plate 740) of the at least four electron-optical elements. As shown in Figure 10, in an embodiment one or more plates may be located downbeam of the most downbeam electron-optical element of the at least four electron-optical elements. For example, a detector plate forming the detector 240 may be positioned downbeam of the most downbeam plate 740 of the lens elements. In an embodiment, the detector 240 is set to a potential different from an adjoining electron-optical element 740 along the path of the charged particle beam as herein disclosed.)

In an embodiment the potential applied to the most downbeam plate 740 of the lens elements is controlled so as to have a fixed potential relative to the sample 208. In a mode of operation of an electron-optical device 40 comprising the electron-optical assembly 700, the potential (or voltage) applied to the most downbeam plate 740 may be maintained to be substantially constant. In an embodiment the voltage (or potential) applied to the most upbeam plate 750 may be controlled to be fixed relative to the source 201 of the electron-optical device 40. When the voltages (or potentials) are controlled to control the landing energy, the electric fields in the electron-optical assembly 700 may change. When the electric fields change, the focus of the electron beams of the sample location may change undesirably. In an embodiment the controller 50 is configured to control the voltages (potentials) applied to the upbeam plate 710 and/or the downbeam plate 720 in order to compensate the change in focus caused by the changing electric fields. The present invention allows the plurality of the electric field between the upbeam plate 710 and the downbeam plate 720 to be varied without unduly increasing the risk of electrical breakdown and/or electron creep. In an embodiment, the detector 240 may be considered a further electron-optical element because it may be set to a potential different from an adjoining electron-optical element 740 along the path of the charged particle beam; alternatively the detector is set to the same potential as the adjoining electron-optical element.

As shown in Figure 10, other plates of the electron-optical assembly 700 may be separated by different types of isolating spacers 750, 760, 770. Some of these spacers 750, 760, 770 may be stepped in structure. Others may have a uniform cross section. As shown in Figure 10 in an embodiment, the detector 240 may be attached to one of the spacers 770 by a connecting element 79. The connecting element 79 may be an electrical isolator with an aperture which may have a surface topography of any other isolator herein disclosed such as an embodiment of the invention. As depicted the isolator has a uniform diameter along the path of the charged particle beam. The detector may have a separate electrical connection from the adjoining electron-optical element 740 along the path of the charged particle beam (e.g. multibeam).

In an embodiment the outer dimensions in the direction across the beam path of the spacers may be greater than the outer dimension of the plates of the electron-optical elements. Alternatively the outer dimensions in the direction across the beam path of the spacers may be substantially the same as the outer dimension of the plates of the electron-optical elements.

In an embodiment the electron-optical assembly 700 comprises one or more electron-optical elements which comprise a microelectromechanical components. The electron-optical assembly 700 may be a module, such as an electron-optical module which may referred to as a MEMS module (for example in view of the nature of one or more of the electron-optical components comprised in the module). In an embodiment the electron-optical assembly 700 can be replaced within the electron-optical device 40.

In the arrangements described herein, the objective lens (for example of the electron-optical assembly 700) is a decelerating lens. Such an objective lens is suited for assessment using signal particles that are secondary signal particles (e.g. secondary electrons from the sample 208). For assessment using signal particles that are backscatter signal particles (e.g, backscatter electrons from the sample) the charged particle beam is comprised of high energy charged particles. For such assessment, the objective lens is an accelerating objective lens. A detector facing the sample surface may have an applied potential to repel secondary signal particles, for example he applied potential is set to the maximum energy of a secondary signal particle e.g. 50 eV. Such an applied repulsion filters to the signal particles to the detector detects just backscatter signal particles. To optimize, desirably maximize, the acceleration of the charged particle beam, the potentials applied to the control lens are set to decelerate the charged particle beam, desirably so that there is a cross-over or intermediate focus of the charged particle beam within the control lens. The potentials applied to the most up beam electrode and the most down beam of the objective lens may be optimized, desirably maximized for the desired acceleration of the charged particle beam towards the sample. Such an arrangement featuring a decelerating control lens with intermediate focus, accelerating objective lens and repelling bottom element of the electron-optical device, such as a detector array, is disclosed in US Application with serial number 17/559,950 filed on 21 December 2022 which hereby incorporated by reference with respect to the listed features, and otherwise in its entirety.

Use of an embodiment of the present invention enables the use of an arrangement charged particle device set to have an accelerating objective lens for assessment with backscatter signal particles and switch the potentials applied to the objective lens to set to operate as a decelerating objective lens without swapping electron-optical components out of the charged particle device and with the risk of electrical breakdown reduced if not prevented. US Application with serial number 17/559,950 discloses a spacer capable of operating in a bidirectional filed and having an intermediate potion of smaller diameter. It was therefore unexpected to the inventor that present invention of a spacer with an intermediate portion of larger diameter had improved bidirectional field performance.

In an embodiment the upbeam electron-optical element and/or the downbeam electron-optical element comprises a semiconductor, for example silicon. In an embodiment each electron-optical element is provided with an electric element configured to connect the electron-optical element to an electrical supply, for example, a voltage supply. Separate voltage supplies may be provided for each electron-optical element. Alternatively, a plurality of the electron-optical element may be connected to the same electrical supply. In an embodiment a plurality of electrical supplies are provided for different parts of the same electron-optical element.

The voltage supplies configured to connect electrically to the electron-optical element. In an embodiment a voltage supply is configured to apply potentials to the different electron-optical elements comprising the upbeam electron-optical element and the downbeam electron-optical element.

In an embodiment the controller 50 is configured to control the voltage supply. In an embodiment the controller 50 is configured to control the potential supply to the upbeam electron-optical element and the downbeam electron-optical element so that the plurality of the electric field between the electron-optical elements is inverted (or reversed). This may allow the controller 50 to compensate for a change in focus in the electron beams that may be caused by controlling the landing energy of the electron beams at the sample location.

In an embodiment the voltage supply is a high voltage power source. In an embodiment the voltage supply is configured to apply a voltage of at least 100 V, optionally at least 200 V, optionally at least 500 V, optionally at least 1 kV, optionally at least 2 kV, optionally at least 5 kV, optionally at least 10 kV and optionally at least 20 kV, for example 25 kV or even 30kV or more to part of the electron-optical assembly 700 relative to a reference potential of the electron-optical device 40. In an embodiment the voltage supply is configured to apply a positive voltage relative to the reference potential. In an alternative embodiment the voltage supply is configured to apply a negative voltage relative to the reference potential. The reference potential may be ground. In an embodiment, one or more of the plates 710, 720 of the electron-optical assembly 700 is configured to be connected to high voltage during use of the electron-optical device 40.

In an embodiment the electron-optical assembly 700 may be controlled to manipulate one or more electron beams. Such a method may comprise applying a potential difference across the upbeam electron-optical element and the downbeam electron-optical element. The potential difference may be changed so that the direction of the electric field between the upbeam electron-optical element and the downbeam electron-optical element is reversed. In an embodiment a controller 50 is used to control the potential differences applied to the upbeam electron-optical element and the downbeam electron-optical element. The isolating spacer 60 electrically isolates the electron-optical element and the downbeam electron-optical element from each other. The isolating spacer 60 defines the spacer aperture 70 around the beam path of the one or more electron beams.

As shown in Figure 6 or Figure 7, for example, in an embodiment the isolating spacer 60 is a single piece of dielectric. The dielectric may comprise at least one of a ceramic, a glass and quartz. The isolating spacer 60 may be formed as an integral component.

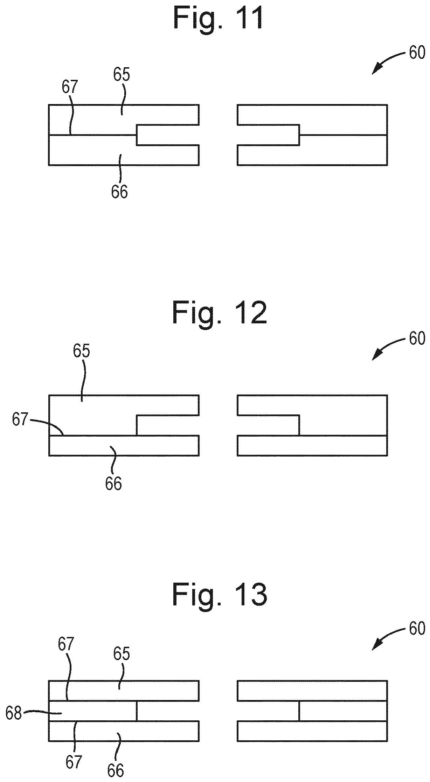

Alternatively, as shown in Figure 11 in an embodiment the isolating spacer 60 comprises two or more pieces 65, 66 of dielectric fixed together. The pieces 65, 66 of dielectric may be secured together. For example, one piece 65 may be attached to the other piece 66. In an embodiment the pieces 65, 66 are joined together at a surface 67. In an embodiment the pieces 65, 66 are bonded together and/or adhered to each other.

As shown in Figure 11, in an embodiment the pieces 65, 66 of dielectric have substantially the same thickness as each other. This allows the same shape of plate to be used as the starting components of both pieces 65, 66 of dielectric. This may reduce the number of different types of component that are required to manufacture the electron-optical assembly 700. An embodiment of the invention is expected to provide an improved isolating spacer 60 without unduly increasing the cost of manufacture. In an embodiment the pieces of the dielectric 65, 66 has substantially the same shape as each other. This allows the pieces 65, 66 to be formed using the same processes before they are secured together to form the isolating spaces 60. This may help to reduce the cost of manufacturing the isolating spacer 60 by reducing the number of different processes required.

It is not essential for the pieces 65, 66 of dielectric to have the same thickness or be the same shape as each other. As shown in Figure 12, in an embodiment the pieces 65, 66 may have different thicknesses and/or different shapes compared to each other. As shown in Figure 12, in an embodiment at least one of the pieces 66 of dielectric has a uniform cross section in a direction parallel to the beam path. The lower piece 66 shown in Figure 12 does not have a step structure. Instead, a uniform cross section results in a flat plate. The lower piece 66 of dielectric may have a particularly simple shape, which may help to reduce the cost of manufacture. Meanwhile, the other piece 65, e.g. the upper piece, may be formed to have a step structure before the pieces 65, 66 are secured together from the isolating spacer 60.

As shown in Figure 13, in an embodiment at least three pieces 65, 66, 68 of dielectric are secured together to form the isolating spacer 60. As shown in Figure 13, in an embodiment each of the pieces 65, 66, 68 of dielectric have a uniform cross section in the direction parallel to the beam path. This allows all of the pieces 65, 66, 68 of dielectric to be formed to have a particularly simple shape. It is not necessary to form a step shape in any single component from which the isolating spacer 60 is formed. This may help to reduce the cost of manufacture of the isolating spacer 60. When the pieces 65, 66, 68 of dielectric are secured together, the isolating spacer 60 is formed to have the stepped structure.

As mentioned above, one or more components from which the isolating spacer 60 is formed may be processed to have a stepped structure for example, in an embodiment a plate is milled, machined, stamped and/or cut in order to form the stepped structure. In an embodiment the components that form the isolating spacer 60 may be shaped by laser ablation. Laser ablation may produce fewer particles for example during manufacture, which may be desirable.

In an embodiment there is provided a method for making an isolating spacer 60 as described above. The isolating spacer 60 is for an electron-optical assembly 700 configured to manipulate one or more electron beams. In an embodiment the method comprises shaping two or more planar pieces 65, 66 of dielectric to have an aperture 70 for a path of one or more electron beams. In an embodiment the method comprises fixing together the two or more planar pieces 65, 66 to form the isolating spacer 60, so that the isolating spacer 60 has an inner surface 61 comprising the inner rims of the two or more planar pieces 65, 66. As a result the isolating spacer 60 comprises an upbeam portion 62 for securing to the upbeam electron-optical element, a downbeam portion 64 for securing to the downbeam electron-optical element and an intermediate portion 63 between the upbeam portion 62 and the downbeam portion 64. The upbeam portion 62 and the downbeam portion 64 protrude relative to the intermediate portion 63 such that the spacer aperture 70 has an increase dimension in a direction across the beam path of the intermediate portion 63 compared to at the upbeam portion 62 and the downbeam portion 64.

In an embodiment there is provided a method for making an electron-optical assembly 700 as described above. In an embodiment the method comprises providing the upbeam electron-optical element and the downbeam electron-optical element each comprising a plate having one or more apertures around a beam path of the one or more electron beams. In an embodiment the method comprises fixing (e.g. securing) the upbeam electron-optical element and the downbeam electron-optical element to either side of a spacer 60 configured to electrically isolate the upbeam electron-optical element and the downbeam electron-optical element on each other. The isolating spacer 60 may be as described as elsewhere in this document.

The electron-optical assembly 700 may comprise or be a lens assembly for manipulating electron beamlets. The lens assembly may, for example, be, or may be part of, an objective lens assembly or a condenser lens assembly. The lens assembly, such as an objective lens assembly, may further comprise an additional lens array comprising at least two plates such as a control lens array 250.

In an embodiment the electron-optical assembly 700 comprises one or more electron-optical elements which comprise an element which may be referred to as a microelectromechanical component (despite such component may not comprise a moving or moveable feature) or may be made using techniques suited to make microelectromechanical components (for example a 'MEMS technique') some of which are designed to have electron-optical functionality. The electron-optical assembly 700, or at least components of the electron-optical assembly 700, may be manufactured by such techniques. The electron-optical assembly 700 may comprise one or more elements which may be considered MEMS elements. One or more of such elements may be controlled to be set at a high potential difference relative to a reference potential (e.g. ground) during use. Such elements may require accurate positioning (for example alignment) within the electron-optical assembly 700 for example with respect to the path of the beam grid and with respect to other electron-optical elements within the device for example with respect to a source, with respect to a sample and/or the path of the beam grid. An embodiment of the invention is expected to allow for more accurate positioning (for example alignment) of such elements within the stack of such an electron-optical assembly 700 such as during operation for example without distortion of the electron-optical assembly 700 for example by externally applied force or moment. An embodiment of the invention may in addition or alternatively enable more accurate positioning, for example alignment, of such elements with respect to other elements in the device 40 and thus of the stack of the electron-optical assembly 700 comprising such elements within the device 40.

As mentioned above, in an embodiment the electron-optical assembly 700 is an electron-optical lens assembly. The electron-optical lens assembly may comprise an objective lens assembly. The electron-optical lens assembly may be an objective lens assembly. In an alternative embodiment the electron-optical lens assembly is an electron-optical condenser lens assembly.

In an embodiment the electron-optical assembly 700 comprises a collimator. For example, in an embodiment the electron-optical assembly 700 comprises a magnetic collimator in combination with an electro static condenser lens arrays. The electron-optical assembly 700 may comprise a single aperture lens array with one or two macro electrodes, placed away from the virtual source conjugate plane.

In an alternative embodiment, the electron-optical assembly 700 comprises a magnetic macro lens in combination with an electrostatic slit deflector. The magnetic macro lens may be for collimating. As a further alternative, in an embodiment the electron-optical assembly 700 comprises a combined magnetic and electrostatic macro lens and a downbeam slit deflector.

In general, the electron-optical assembly 700 may comprise any plates such as a plate of a detector array, a plate of a lens electrode (into which multiple deflectors may be integrated) multiple deflector arrays, beam aperture arrays (e.g. an upper beam aperture array and/or a final beam limiting array), deflector arrays (e.g. strip deflector arrays) and other types of corrector elements.

The embodiments described within this document have focussed primarily on multi-beam electron-optical devices 40. The invention is equally applicable to single-beam electron-optical devices 40.

A plurality of electron-optical devices may be comprised in an electron-optical device array. The electron-optical devices of the electron-optical device array are preferably be configured to focus respective multi-beams simultaneously onto different regions of the same sample.

While the present invention has been described in connection with various embodiments, other embodiments of the invention will be apparent to those skilled in the art from consideration of the specification and practice of the invention disclosed herein. For example, as described above in an embodiment the electron-optical assembly 700 comprises the electrical connector 60. However, an electrical connector 60 of the invention can be used anywhere in the electron-optical device 40 where a problem of possible electrical breakdown may exist. In an embodiment the electron-optical device 40 comprises the electrical connector 60 separately from the electron-optical assembly 700. For example the electrical connector 60 may be located where a low force electrical connection with other parts of the electron-optical device 40 such as the body or frame of the electron-optical device 40 is desirable. The electrical connector 60 may be located where the electrical connection is not required to be particularly low force. The electrical connector 60 may make the electron-optical device 40 more compact while providing a field free region. It is intended that the specification and examples be considered as exemplary only, with a true scope and spirit of the invention being indicated by the following claims.

The descriptions above are intended to be illustrative, not limiting. Thus, it will be apparent to one skilled in the art that modifications may be made as described without departing from the scope of the claims and clauses set out below.

There is provided the following clauses.

Clause 1. An isolating spacer for a charged particle-optical assembly for manipulating one or more charged particle beams between an upbeam charged particle-optical element and a downbeam charged particle-optical element that are controllable to have inverting polarity with respect to each other, the isolating spacer configured to electrically isolate the upbeam charged particle-optical element and the downbeam charged particle-optical element from each other, in the isolating spacer is defined a spacer aperture around a beam path of one or more charged particle beams, the isolating spacer comprises: an upbeam portion configured to be adjacent to an upbeam charged particle-optical element, a downbeam portion configured to be adjacent to an downbeam charged particle-optical element and an intermediate portion between the upbeam portion and the downbeam portion, wherein the upbeam portion and the downbeam portion protrude relative to the intermediate portion such that the spacer aperture has an increased dimension in a direction across the beam path at the intermediate portion compared to at the upbeam portion and the downbeam portion.

Clause 2. A charged particle-optical assembly configured to manipulate one or more charged particle beams, the charged particle-optical assembly comprising: an upbeam charged particle-optical element and a downbeam charged particle-optical element each comprising a plate having one or more apertures around a beam path of the one or more charged particle beams; and the isolating spacer of clause 1, the upbeam charged particle optical element configure to be adjacent the upbeam portion and the downbeam charged particle optical element configured to be adjacent the down beam portion.

Clause 3. A charged particle-optical assembly configured to manipulate one or more charged particle beams, the charged particle-optical assembly comprising: an upbeam charged particle-optical element and a downbeam charged particle-optical element each comprising a plate having one or more apertures around a beam path of the one or more charged particle beams; and an isolating spacer configured to electrically isolate the upbeam charged particle-optical element and the downbeam charged particle-optical element from each other, the isolating spacer defining a spacer aperture around the beam path of the one or more charged particle beams; wherein the isolating spacer comprises an upbeam portion adjacent to the upbeam charged particle-optical element, a downbeam portion adjacent to the downbeam charged particle-optical element and an intermediate portion between the upbeam portion and the downbeam portion, wherein the upbeam portion and the downbeam portion protrude relative to the intermediate portion such that the spacer aperture has an increased dimension in a direction across the beam path at the intermediate portion compared to at the upbeam portion and the downbeam portion.

Clause 4. The charged particle-optical assembly of clause 2 or 3, wherein the isolating spacer is shaped such that the spacer aperture has a similar dimension in the direction across the beam path at the upbeam portion and at the downbeam portion.

Clause 5. The charged particle-optical assembly of any of clauses 2-4, wherein the isolating spacer is shaped to be symmetrical about a plane across the beam path.

Clause 6. The charged particle-optical assembly of clause 5, wherein the plane is through the intermediate portion.

Clause 7. The charged particle-optical assembly of any of clauses 2-6, wherein the isolating spacer is shaped such that when a potential difference is applied across the charged particle-optical elements, an electric potential at a protruding corner of the upbeam portion and/or the downbeam portion at which the dimension of the spacer aperture changes is a local extremum, wherein optionally the charged particle-optical assembly comprises: a voltage supply electrically connected to at least one of the charged particle-optical elements; and a controller configured to control a potential difference applied by the voltage supply across the charged particle-optical elements.

Clause 8. The charged particle-optical assembly of any of clauses 2-7, wherein the isolating spacer is shaped such that there is a step change in the dimension of the spacer aperture in the direction across the beam path between the intermediate portion and the upbeam portion and/or the downbeam portion.

Clause 9. The charged particle-optical assembly of clause 8, wherein, the step change in dimension corresponds to the protruding corner of the upbeam portion and/or the downbeam portion respectively.

Clause 10. The charged particle-optical assembly of any of clauses 2-9, wherein the isolating spacer is shaped such that a difference in dimension of the spacer aperture in the direction across the beam path at the intermediate portion compared to at the upbeam portion and/or the downbeam portion is at least 20%, optionally at least 50%, optionally at least 100%, optionally at least 200% and optionally at least 500% of a thickness of the isolating spacer

Clause 11. The charged particle-optical assembly of any of clauses 2-10, wherein the isolating spacer is a single piece of dielectric.

Clause 12. The charged particle-optical assembly of any of clauses 2-10, wherein the isolating spacer comprises two or more pieces of dielectric fixed together.

Clause 13. The charged particle-optical assembly of clause 12, wherein the pieces of dielectric have substantially a same thickness as each other.

Clause 14. The charged particle-optical assembly of clause 13, wherein the pieces of dielectric have substantially a same shape as each other.

Clause 15. The charged particle-optical assembly of any of clauses 12-14, wherein at least one of the pieces of dielectric has a uniform cross section in a direction parallel to the beam path.

Clause 16. The charged particle-optical assembly of clause 15, wherein each of the pieces of dielectric has a uniform cross section in a direction parallel to the beam path.

Clause 17. The charged particle-optical assembly of any of clauses 11-16, wherein the dielectric comprises at least one of a ceramic, a glass and quartz.

Clause 18. The charged particle-optical assembly of any preceding clause, wherein the charged particle-optical assembly is a charged particle-optical lens assembly.

Clause 19. The charged particle-optical assembly of clause 18, wherein the charged particle-optical lens assembly comprises an objective lens assembly.

Clause 20. The charged particle-optical assembly of clause 18, wherein the charged particle-optical lens assembly is an objective lens assembly.

Clause 21. The charged particle-optical assembly of clause 19 or 20, wherein the objective lens assembly comprises at least one of an objective lens and a control lens, desirably the charged particle lens assembly is the control lens, desirably the objective lens comprising at least two charged particle-optical elements each comprising a plate having one or more apertures around a beam path of the one or more charged particle beams, desirably the control lens array comprising at least three charged particle-optical elements each comprising a plate having one or more apertures around a beam path of the one or more charged particle beams, desirably a most upbeam charged particle optical element of the objective lens comprising a most down beam charged particle optical element of the control lens.

Clause 22. The charged particle-optical assembly of clause 18, wherein the charged particle-optical lens assembly comprises a condenser lens assembly.

Clause 23. The charged particle-optical assembly of any of clauses 2-22, wherein the charged particle-optical assembly comprises a collimator.

Clause 24. The charged particle-optical assembly any of clauses 2-23, wherein the charged particle-optical assembly comprises an individual beam corrector.

Clause 25. The charged particle-optical assembly of any of clauses 2-24, wherein the charged particle-optical assembly comprises a deflector.

Clause 26. The charged particle-optical assembly of any of clauses 2-25, wherein the charged particle-optical assembly comprises at least four charged particle-optical elements each comprising a plate having one or more apertures around a beam path of the one or more charged particle beams.

Clause 27. The charged particle-optical assembly of clause 26, wherein the upbeam charged particle-optical element and the downbeam charged particle-optical element electrically isolated from each other by the isolating spacer are located between a most upbeam charged particle-optical element and a most downbeam charged particle-optical element of the at least four charged particle-optical elements.

Clause 28. The charged particle-optical assembly of any of clauses 2-27, wherein the charged particle-optical assembly comprises one or more charged particle-optical elements which comprise a microelectromechanical component.

Clause 29. The charged particle-optical assembly of any of clauses 2-28, wherein the upbeam charged particle-optical element and/or the downbeam charged particle-optical element comprises a semiconductor for example silicon.

Clause 30. The charged particle-optical assembly of any of clauses 2-29 further comprising, for each charged particle optical element, an electrical connection configured to connect the charged particle-optical element to an electrical supply for example a voltage supply.

Clause 31. A charged particle-optical device for projecting a plurality of charged particle beams along respective beam paths towards a sample location, the charged particle-optical device comprising the isolating spacer of clause 1 or the charged particle-optical assembly of any of clauses 2-30.

Clause 32. The charged particle-optical device of clause 31, further comprising a voltage supply configured to connect electrically to the charged particle-optical elements desirably to apply potentials to the different charged particle optical elements comprising the upbeam charged particle-optical element and the downbeam charged particle-optical element.

Clause 33. The charged particle-optical device of clause 32, further comprising a controller configured to control the voltage supply desirably the potentials applied to the upbeam charged particle-optical element and the downbeam charged particle-optical element so that the polarity of an electric field between the charged particle-optical elements is inverted/reversed.

Clause 34. A charged particle-optical apparatus comprising: the isolating spacer of clause 1, the charged particle-optical assembly of any of clauses 2-30 or the charged particle-optical device of any of clauses 31-33; and an actuatable stage configured to support a sample.

Clause 35. A method for electrically isolating an upbeam charged particle-optical element and a downbeam charged particle-optical element from each other in a charged particle-optical assembly configured to manipulate one or more charged particle beams, the method comprising: providing an upbeam charged particle-optical element and a downbeam charged particle-optical element each comprising a plate having one or more apertures around a beam path of the one or more charged particle beams; electrically isolating the upbeam charged particle-optical element and the downbeam charged particle-optical element from each other with an isolating spacer, the isolating spacer defining a spacer aperture around the beam path of the one or more charged particle beams; wherein the isolating spacer comprises an upbeam portion adjacent to the upbeam charged particle-optical element, a downbeam portion adjacent to the downbeam charged particle-optical element and an intermediate portion between the upbeam portion and the downbeam portion, wherein the upbeam portion and the downbeam portion protrude relative to the intermediate portion such that the spacer aperture has an increased dimension in a direction across the beam path at the intermediate portion compared to at the upbeam portion and the downbeam portion.

Clause 36. A method for controlling a charged particle-optical assembly to manipulate one or more charged particle beams, the method comprising: applying a potential difference across an upbeam charged particle-optical element and a downbeam charged particle-optical element each comprising a plate having one or more apertures around a beam path of the one or more charged particle beams; and changing the potential difference so that a direction of an electric field between the upbeam charged particle-optical element and the downbeam charged particle-optical element is reversed, optionally using a controller to control the potential differences applied to the upbeam charged particle-optical element and the downbeam charged particle-optical element; wherein an isolating spacer electrically isolates the upbeam charged particle-optical element and the downbeam charged particle-optical element from each other, the isolating spacer defining a spacer aperture around the beam path of the one or more charged particle beams; wherein the isolating spacer comprises an upbeam portion adjacent to the upbeam charged particle-optical element, a downbeam portion adjacent to the downbeam charged particle-optical element and an intermediate portion between the upbeam portion and the downbeam portion, wherein the upbeam portion and the downbeam portion protrude relative to the intermediate portion such that the spacer aperture has an increased dimension in a direction across the beam path at the intermediate portion compared to at the upbeam portion and the downbeam portion.

Clause 37. A method for making an isolating spacer for a charged particle-optical assembly configured to manipulate one or more charged particle beams, the isolating spacer configured to electrically isolate the upbeam charged particle-optical element and the downbeam charged particle-optical element from each other, the isolating spacer defining a spacer aperture around the beam path of the one or more charged particle beams, the method comprising: shaping two or more planar pieces of dielectric to have an aperture for a path of one or more charged particle beams, the different apertures having an inner rim; and fixing together the two or more planar pieces to form the isolating spacer, so that the isolating spacer has an inner surface comprising the inner rims of the two or more planar pieces such that the isolating spacer comprising an upbeam portion for securing to the upbeam charged particle-optical element, a downbeam portion for securing to the downbeam charged particle-optical element and an intermediate portion between the upbeam portion and the downbeam portion, the upbeam portion and the downbeam portion protruding relative to the intermediate portion such that the spacer aperture has an increased dimension in a direction across the beam path at the intermediate portion compared to at the upbeam portion and the downbeam portion.

Clause 38. The method of clause 37, wherein the two or more pieces of dielectric have substantially a same thickness as each other, desirably the shaping of the two or more planar pieces comprises shaping the two or more planar pieces to have substantially the same thickness of each other.

Clause 39. The method of any clause 37 or 38, wherein at least one of the pieces of dielectric has a uniform cross section in a direction of, desirably parallel to, the beam path, desirably the forming of at least one of the planar pieces comprises forming the at least one planar piece to have a uniform cross-section in the direction of the beam path.

Clause 40. The method of clause 39, wherein each of the pieces of dielectric has a uniform cross section in a direction parallel to the beam path, desirably the forming of the planar pieces comprises forming the planar piece to have a uniform cross-section in the direction of the beam path

Clause 41. The method of any of clauses 37 to 40 comprising: forming a step in the inner rim of at least one of the two or more planar pieces, the step having a smaller thickness than the planar piece in the direction of the path of on one or more charged particle beams; and the fixing comprising fixing the two or more planar pieces such that the inner surface comprising the at least one inner rim comprising the step, the or each step comprised in the inner surface between the intermediate portion and one of the upbeam portion and the down beam portion.

Clause 42. The method of clause 37, 38 or 41, wherein the pieces of dielectric have substantially a same shape as each other, desirably the shaping of the two or more planar pieces comprises shaping the two or more planar pieces to have substantially the same shape.

Clause 43. A method for making a charged particle-optical assembly configured to manipulate one or more charged particle beams, the method comprising providing an isolating spacer comprising the method of making the isolating spacer of any of clauses 37 to 42; and providing an upbeam charged particle-optical element and a downbeam charged particle-optical element each comprising a plate having one or more apertures around a beam path of the one or more charged particle beams; and fixing the upbeam charged particle-optical element and the downbeam charged particle-optical element to either side of the isolating spacer;

Clause 44. A method for making a charged particle-optical assembly configured to manipulate one or more charged particle beams, the method comprising: providing an upbeam charged particle-optical element and a downbeam charged particle-optical element each comprising a plate having one or more apertures around a beam path of the one or more charged particle beams; and fixing the upbeam charged particle-optical element and the downbeam charged particle-optical element to either side of an isolating spacer configured to electrically isolate the upbeam charged particle-optical element and the downbeam charged particle-optical element from each other, the isolating spacer defining a spacer aperture around the beam path of the one or more charged particle beams; wherein the isolating spacer comprises an upbeam portion adjacent to the upbeam charged particle-optical element, a downbeam portion adjacent to the downbeam charged particle-optical element and an intermediate portion between the upbeam portion and the downbeam portion, wherein the upbeam portion and the downbeam portion protrude relative to the intermediate portion such that the spacer aperture has an increased dimension in a direction across the beam path at the intermediate portion compared to at the upbeam portion and the downbeam portion.

Clause 45. The method of clause 44, comprising forming the isolating spacer from a single piece of dielectric, desirably the dielectric comprises at least one of a ceramic, a glass and quartz.

Clause 46. The method of clause 44, comprising forming the isolating spacer by fixing together two or more pieces of dielectric together.

Clause 47. The method of clause 46, wherein the pieces of dielectric have substantially a same thickness as each other.

Clause 48. The method of clause 47, wherein the pieces of dielectric have substantially a same shape as each other.

Clause 49. The method of any of clauses 46-48, wherein at least one of the pieces of dielectric has a uniform cross section in a direction parallel to the beam path.

Clause 50. The method of clause 49, wherein each of the pieces of dielectric has a uniform cross section in a direction parallel to the beam path.

## Claims

1. A charged particle-optical assembly configured to manipulate one or more charged particle beams, the charged particle-optical assembly comprising:
an upbeam charged particle-optical element and a downbeam charged particle-optical element each comprising a plate having one or more apertures around a beam path of the one or more charged particle beams; and
an isolating spacer configured to electrically isolate the upbeam charged particle-optical element and the downbeam charged particle-optical element from each other, the isolating spacer defining a spacer aperture around the beam path of the one or more charged particle beams;
wherein the isolating spacer comprises an upbeam portion adjacent to the upbeam charged particle-optical element, a downbeam portion adjacent to the downbeam charged particle-optical element and an intermediate portion between the upbeam portion and the downbeam portion, wherein the upbeam portion and the downbeam portion protrude relative to the intermediate portion such that the spacer aperture has an increased dimension in a direction across the beam path at the intermediate portion compared to at the upbeam portion and the downbeam portion.

2. The charged particle-optical assembly of claim 1, wherein the isolating spacer is shaped such that the spacer aperture has a similar dimension in the direction across the beam path at the upbeam portion and at the downbeam portion.

3. The charged particle-optical assembly of any of claims 1 or 2, wherein the isolating spacer is shaped to be symmetrical about a plane across the beam path.

4. The charged particle-optical assembly of claim 3, wherein the plane is through the intermediate portion.

5. The charged particle-optical assembly of any of claims 1 to 4, wherein the isolating spacer is shaped such that when a potential difference is applied across the charged particle-optical elements, an electric potential at a protruding corner of the upbeam portion and/or the downbeam portion at which the dimension of the spacer aperture changes is a local extremum,

6. The charged particle-optical assembly of any of claims 5, wherein the charged particle-optical assembly comprises:
a voltage supply electrically connected to at least one of the charged particle-optical elements; and
a controller configured to control a potential difference applied by the voltage supply across the charged particle-optical elements.

7. The charged particle-optical assembly of any of claims 1 to 6, wherein the isolating spacer is shaped such that there is a step change in the dimension of the spacer aperture in the direction across the beam path between the intermediate portion and the upbeam portion and/or the downbeam portion.

8. The charged particle-optical assembly of claim 7, wherein, the step change in dimension corresponds to the protruding corner of the upbeam portion and/or the downbeam portion respectively.

9. The charged particle-optical assembly of any of claims 1 to 8, wherein the isolating spacer is a single piece of dielectric.

10. The charged particle-optical assembly of any of claims 1 to 9, wherein the isolating spacer comprises two or more pieces of dielectric fixed together.

11. The charged particle-optical assembly of claim 10, wherein the pieces of dielectric have substantially a same thickness as each other and desirably the pieces of dielectric have substantially a same shape as each other.

12. The charged particle-optical assembly of claim 10 or 11, wherein at least one of the pieces of dielectric has a uniform cross section in a direction parallel to the beam path.

13. The charged particle-optical assembly of claim 12, wherein each of the pieces of dielectric has a uniform cross section in a direction parallel to the beam path.

14. The charged particle-optical assembly of any preceding claim, wherein the charged particle-optical assembly is a charged particle-optical lens assembly.

15. The charged particle-optical assembly of claim 14, wherein the charged particle-optical lens assembly comprises an objective lens assembly.
